# EUROPEAN PATENT APPLICATION

(11) **EP 4 738 009 A1**
(43) Date of publication of application: **06.05.2026**
(21) Application number: 24831868.5
(22) Date of filing: 21.06.2024
(51) Int. Cl.: G03F 7/004, G03F 7/023, G03F 7/027, G03F 7/037, G03F 7/038, G03F 7/075, H01L 21/312

(54) **PHOTOSENSITIVE RESIN COMPOSITION, CURED PRODUCT, AND ELECTRONIC COMPONENT**

(30) Priority: 27.06.2023 JP 2023104743
(71) Applicant: Toray Industries, Inc., Tokyo 103-8666 (JP)
(72) Inventor: KANEKI, Takayuki, Otsu-shi, Shiga 520-8558 (JP); HIBINO, Chika, Otsu-shi, Shiga 520-8558 (JP); ARAKI, Hitoshi, Otsu-shi, Shiga 520-8558 (JP)
(74) Representative: Kador & Partner Part mbB
(86) International application number: PCT/JP2024/022584
(87) International publication number: WO 2025/005007

(57) **Abstract**

An object of the present invention is to provide a cured product that is to be provided in an electronic component, and has excellent heat resistance, excellent adhesion to a metal material, particularly to copper, and excellent migration resistance. The gist of the present invention is to provide a photosensitive resin composition including a resin (A), a photosensitizer (B), a compound (C) represented by Formula (1), and a compound (D) represented by Formula (2).

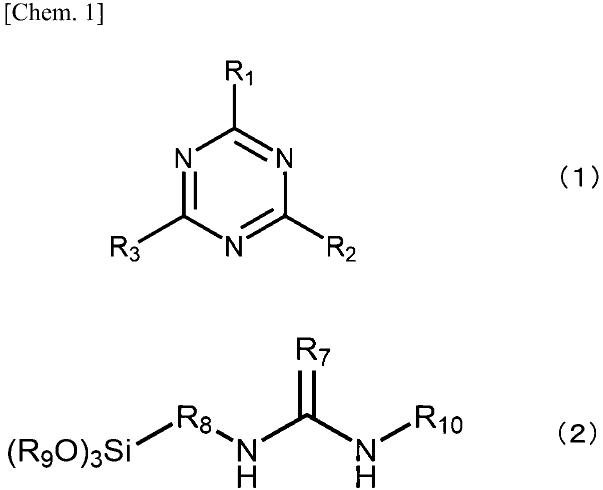

## Description

### Technical Field

The present invention relates to a photosensitive resin composition, a cured product, and an electronic component.

### Background Art

Polyimide resins, polybenzoxazole resins, and the like, which have excellent heat resistance and mechanical properties, have been widely used for surface protective films of and interlayer insulating films of semiconductor elements in electronic devices. In a case where a polyimide or a polybenzoxazole is used for a surface protective film or an interlayer insulating film, one method of forming a through-hole or the like is etching for which a positive photoresist is used. However, this method has a problem in that the method involves the steps of applying and peeling a photoresist, and is complicated. In view of this, a heat-resistant material provided with photosensitivity has been studied with a view to streamlining the working processes (see, for example, Patent Literature 1 to 3).

On the other hand, in a case where a heat-resistant resin composition is used for semiconductor applications or the like, a film heat-cured remains as a permanent film inside a device, and thus, the physical properties of the cured film after the heating are very important. The cured film needs reliability related to high electrical insulation, and thus, also needs high migration resistance. In order to ensure the reliability of a semiconductor package, what is important is adhesion to a material formed on the surface of a semiconductor chip. In particular, in a case where the material is used, for example, as an insulating film between wiring layers in a wafer level package, the adhesion of the material to a metal material used for electrodes and wiring is important. A heat-resistant resin, owing to the rigid main chain structure, is generally considered not to have high strength of adhesion to a metal material. In particular, in the case of a cured resin film formed from a resin composition provided with photosensitivity, additives included in the composition, such as a photosensitizer, sensitizer, acid generator, and a solubility modifier, remain in the cured film even after the heat curing. Thus, the cured film has lower strength of adhesion than a cured film containing no additive.

Specific examples of methods of improving adhesion to a metal material include: a positive photosensitive resin composition composed of an alkaline aqueous solution-soluble polymer, a photoacid generator, and a silane compound containing four or more specific functional groups each directly bound to an aluminium atom, titanium atom, or silicon atom (see Patent Literature 4); and a heat-resistant resin precursor composition composed of: a heat-resistant resin precursor such as a polyimide precursor; and a specific amino compound or a thiol derivative (see Patent Literature 5).

### Citation List

### Patent Literature

Patent Literature 1: JP S49-115541 A
Patent Literature 2: JP S59-108031 A
Patent Literature 3: JP S59-219330 A
Patent Literature 4: JP 2008-276190 A
Patent Literature 5: JP 2007-39486 A

### Summary of Invention

### Technical Problem

However, these resin compositions have problems with providing a cured product that has all of excellent heat resistance, adhesion to a metal material, particularly to copper, and migration resistance. Accordingly, there is a demand for further enhancement in the properties of a photosensitive composition. An object of the present invention is to provide a cured product that is to be included in an electronic component, and has excellent heat resistance, excellent adhesion to a metal material, particularly to copper, and excellent migration resistance.

### Solution to Problem

In order to solve the above-described problems, the present invention relates to the following.
[1] A photosensitive resin composition including a resin (A), a photosensitizer (B), a compound (C) represented by Formula (1), and a compound (D) represented by Formula (2): 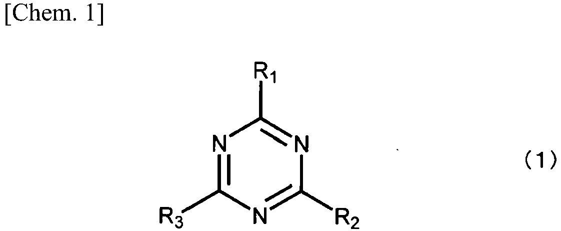
   (R₁ to R₃ are each independently a hydrogen atom, NR₄R₅, or L(R₆)ₛ. L is a C₆₋₁₀ n-valent organic group having an aromatic ring, R₄ and R₅ are each independently a hydrogen atom, -CH₂OH, -CH₂OCH₃, -CH₂OCH₂CH₂CH₂CH₃, or - CH₂OCH(CH₃)₂, and R₆ is independently -CH₂OH, -CH₂OCH₃, - CH₂OCH₂CH₂CH₂CH₃, or -CH₂OCH(CH₃)₂. n is an integer of 1 to 3, s is an integer of 0 to 2, and n - s is 1.) 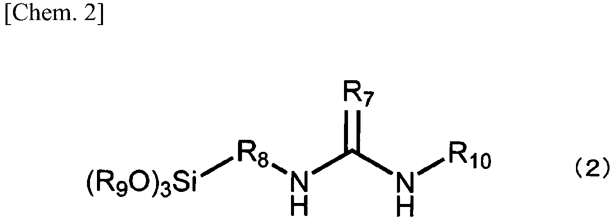
   (R₇ is an oxygen atom or a sulfur atom. R₈ is a C₁₋₄ divalent organic group, and R₉ is a methyl group or an ethyl group. R₁₀ is a C₁₋₁₈ monovalent hydrocarbon group or a C₆₋₁₂ monovalent aromatic group, wherein the C₁₋₁₈ monovalent hydrocarbon group and the C₆₋₁₂ monovalent aromatic group may contain a heteroatom.)
[2] The photosensitive resin composition according to [1], wherein all or part of the photosensitizer (B) is an oxime ester compound (B1-1).
[3] The photosensitive resin composition according to [1] or [2], wherein the compound (C) represented by Formula (1) is contained in an amount of 30 parts by mass or more and 1200 parts by mass or less with respect to 100 parts by mass of the compound (D) represented by Formula (2).
[4] The photosensitive resin composition according to any one of [1] to [3], which satisfies α > β ≥ y, satisfies 1.0 < α/β ≤ 4.5, and satisfies 0.4 ≤ β/γ ≤ 5.0, assuming that the amount of the photosensitizer (B) contained in the photosensitive resin composition is α part(s) by mass, that the amount of the compound (C) represented by Formula (1) is β part(s) by mass, and the amount of the compound (D) represented by Formula (2) is γ part(s) by mass.
[5] The photosensitive resin composition according to any one of [1] to [4], further including one or both of a compound represented by Formula (5) and a compound represented by Formula (6): 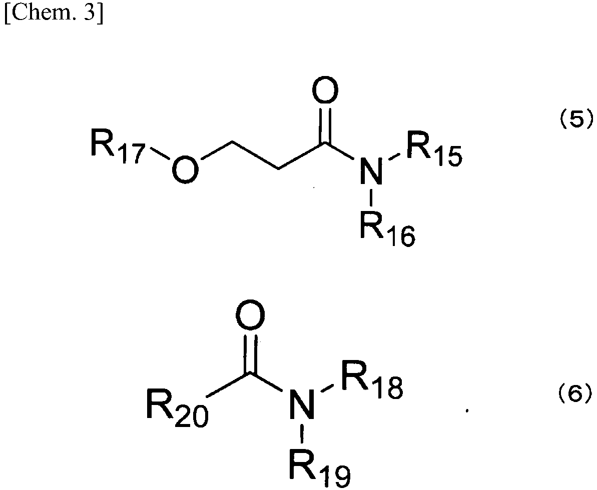 (In Formula (5), R₁₅, R₁₆, and R₁₇ are each independently a C₁₋₆ alkyl group. In Formula (6), R₁₈ and R₁₉ are each independently a C₁₋₆ alkyl group. R₂₀ is a hydrogen atom or a C₁₋₆ alkyl group.)
[6] The photosensitive resin composition according to any one of [1] to [5], wherein all or part of the compound (D) represented by Formula (2) is a compound having a structure represented by Formula (4): 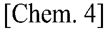 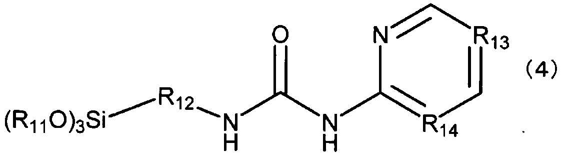
   (R₁₁ is a methyl group or an ethyl group. R₁₂ is a C₁₋₄ divalent organic group.
   R₁₃ and R₁₄ are each independently a carbon atom (i.e., a methine group) or a nitrogen atom.)
[7] The photosensitive resin composition according to any one of [1] to [6], wherein all or part of the compound (C) represented by Formula (1) is a compound having a structure represented by Formula (3): 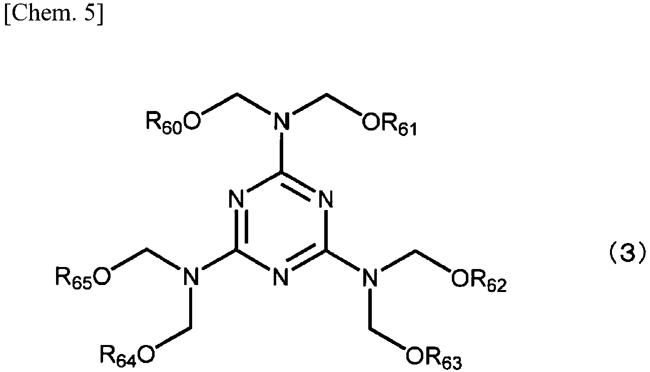 (R₆₀ to R₆₅ are each independently a hydrogen atom, -CH₃, -CH₂CH₂CH₂CH₃, or -CH(CH₃)₂.)
[8] The photosensitive resin composition according to any one of [1] to [7], wherein all or part of the resin (A) is one or more resins selected from the group consisting of a polyimide precursor (A-1), a polyimide (A-2), a polybenzoxazole precursor (A-3), a polybenzoxazole (A-4), and copolymers thereof.
[9] The photosensitive resin composition according to any one of [1] to [8], wherein the one or more resins selected from the group consisting of the polyimide precursor (A-1), the polyimide (A-2), the polybenzoxazole precursor (A-3), the polybenzoxazole (A-4), and the copolymers thereof contain(s) a phenolic hydroxyl group.
[10] The photosensitive resin composition according to any one of [1] to [9], wherein all or part of the resin (A) is a polyimide precursor containing a repeating structural unit represented by Formula (7), or is a copolymer of the polyimide precursor. 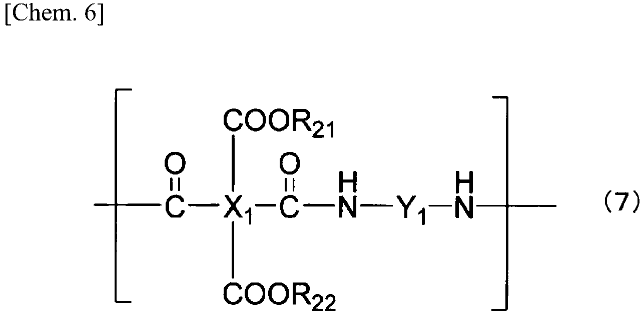 (X₁ is a tetravalent group having a C₂₋₂₀ aliphatic structure, a C₄₋₂₀ alicyclic structure, or a C₄₋₄₀ aromatic structure; Y₁ is a divalent organic group having a C₂₋₂₀ aliphatic structure, a C₄₋₂₀ alicyclic structure, or a C₄₋₄₀ aromatic structure; and R₂₁ and R₂₂ are each independently a hydrogen atom, a C₁₋₂₀ alkyl group, or a monovalent organic group having an ethylene-type unsaturated double bond.)
[11] The photosensitive resin composition according to [10], wherein the polyimide precursor has an esterification rate of 40 mol% or more and 80 mol% or less.
[12] The photosensitive resin composition according to [10], wherein all or part of the structure of X₁ in Formula (7) is a structure represented by Formula (8): 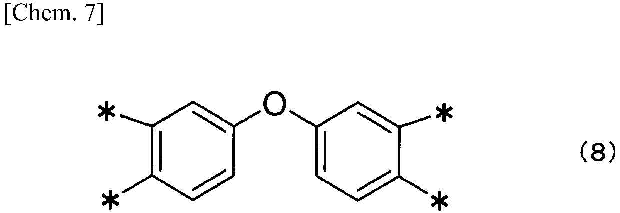 (In Formula (8), * is a binding site that binds to an amide structure, a carboxylic acid structure, or a carboxylic acid ester structure.)
[13] The photosensitive resin composition according to any one of [1] to [12], wherein the photosensitive resin composition contains a halogen element(s) in an amount of 50 ppm or less.
[14] A cured product obtained by curing the photosensitive resin composition according to any one of [1] to [13].
[15] An electronic component including the cured product according to [14].
[16] The electronic component according to [15], wherein the electronic component includes: a silicon substrate, a silicon carbide substrate, or a gallium nitride substrate, wherein the cured product is provided on the substrate.

### Advantageous Effects of Invention

A photosensitive resin composition according to the present invention can provide a cured product having excellent adhesion to copper wiring and excellent heat resistance. In addition, the photosensitive resin composition can provide a cured product that has excellent migration resistance, and is to be included in an electronic component. In addition, an electronic component according to the present invention can provide an electronic component having excellent migration resistance.

### Description of Embodiments

A photosensitive composition in a first aspect of the present invention will be described below. However, the present invention is not limited to the following embodiments, and obviously can be carried out with various modifications to the extent that the modifications enable an object of the invention to be achieved, and do not depart from the gist of the invention.

Hereinafter, an "organic group" means: a hydrocarbon group optionally substituted with a substituent such as a halogen, cyano group, nitro group, carboxyl group, hydroxyl group, oxyalkyl group, or oxyaryl group; and an atomic group in which such hydrocarbon groups are linked by a linking group such as an ether bond, sulfide bond, sulfone bond, or ester bond.

### <Photosensitive resin composition>

A photosensitive resin composition in a first aspect of the present invention is a photosensitive resin composition containing a resin (A) (hereinafter referred to as the "component (A)" in some cases), a photosensitizer (B) (hereinafter referred to as the "component (B)" in some cases), a compound (C) represented by Formula (1) (hereinafter referred to as the "component (C)" in some cases), and a compound (D) represented by Formula (2) (hereinafter referred to as the "component (D)" in some cases). 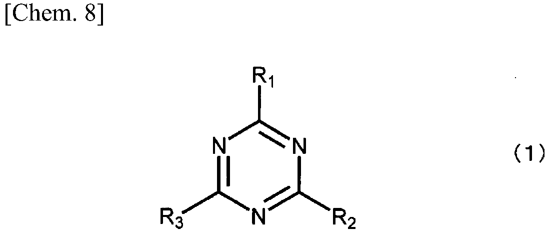
(R₁ to R₃ are each independently a hydrogen atom, NR₄R₅, or L(R₆)ₛ. L is a C₆₋₁₀ n-valent organic group having an aromatic ring, R₄ and R₅ are each independently a hydrogen atom, -CH₂OH, -CH₂OCH₃, -CH₂OCH₂CH₂CH₂CH₃, or - CH₂OCH(CH₃)₂. In a case where a plurality of R₆s are present, the R₆s are each independently -CH₂OH, -CH₂OCH₃, -CH₂OCH₂CH₂CH₂CH₃, or -CH₂OCH(CH₃)₂. n is an integer of 1 to 3, s is an integer of 0 to 2, and n - s is 1.) 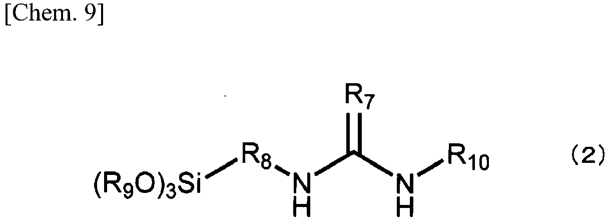
(R₇ is an oxygen atom or a sulfur atom. R₈ is a C₁₋₄ divalent organic group, and R₉ is a methyl group or an ethyl group. R₁₀ is a C₁₋₁₈ monovalent hydrocarbon group or a C₆₋₁₂ monovalent aromatic group, wherein the C₁₋₁₈ monovalent hydrocarbon group and the C₆₋₁₂ monovalent aromatic group may contain a heteroatom.)

Adopting the above-described constitution enables a photosensitive resin composition according to the present invention to be improved in adhesion to a metal material, particularly to copper. Enhancing the crosslink density of the resin makes it possible to provide a cured product having excellent heat resistance.

A photosensitive resin composition according to the present invention preferably satisfies α > β ≥ y, satisfies 1.0 ≤ α/β ≤ 4.5, and satisfies 0.4 ≤ β/γ ≤ 5.0, assuming that the amount of the component (B) is α part(s) by mass, that the amount of the component (C) is β part(s) by mass, and the amount of the component (D) is γ part(s) by mass, when the amount of the component (A) is 100 parts by mass. Satisfying such conditions further enhances adhesion to copper wiring, and enhances the crosslink density of the resin, thus making it possible to provide a cured product having excellent heat resistance.

The total amount of halogen elements (fluorine, chlorine, bromine, and iodine) contained in a photosensitive resin composition according to the present invention is preferably 50 ppm or less. Bringing, to 50 ppm or less, the amount of the halogen elements contained in the photosensitive resin composition makes it possible to reduce the environmental load and improve the migration resistance. The amount of the halogen elements contained in the photosensitive resin composition is measured by an analytical method based on IEC 62321-3-2. In a pretreatment, a sample is combusted, using a technique based on BS EN 14582, the combustion gas containing halogens is absorbed into an absorbing liquid, and the absorbing liquid is measured, using an ion chromatograph. The details of this are as explained in the Examples section.

### <Resin (A) (component (A))>

The resin (A) contained in a photosensitive resin composition according to the present invention is a resin having heat resistance to such an extent that, even when the photosensitive resin composition is cured, not all of the composition disappears. The resin (A) is preferably a resin that is cured by forming a crosslinked structure through a reaction. The curing reaction is not particularly limited, may be caused by heating, irradiation with energy beam, or the like, and may also be caused by forming a crosslinked structure with the below-described crosslinking agent (F). The resin (A) is preferably a thermosetting resin.

In addition, the resin (A) is preferably an alkali-soluble resin or an organic solvent-soluble resin. The alkali-soluble resin refers to a resin soluble in an alkaline developer. The organic solvent-soluble resin refers to a resin soluble in an organic solvent developer. The alkali-soluble resin and organic solvent-soluble resin in a photosensitive composition according to the present invention are preferably resins having solubility such that the composition is provided with positive or negative photosensitivity by the below-described photosensitizer (B), and can be developed with an alkaline developer or an organic solvent to have a positive or negative pattern formed therein. The alkali-soluble group contained in the resin (A) is preferably a phenolic hydroxyl group, hydroxyimide group, hydroxyamide group, silanol group, 1,1-bis(trifluoromethyl)methylol group, mercapto group, carboxyl group, carboxylic acid anhydride group, or sulfonic acid group.

In addition, the resin (A) preferably has a radically polymerizable group. The radically polymerizable group is preferably a group having an ethylene-type unsaturated double bond. Among these, a C₂₋₅ alkenyl group or a C₂₋₅ alkynyl group is more preferable, and a styryl group, cinnamoyl group, maleimide group, or (meth)acryloyl group is preferable. From the viewpoints of enhancing sensitivity during exposure and promoting radical polymerization during heating at low temperature, a (meth)acryloyl group is more preferable. On the other hand, the C₂₋₅ alkenyl group or the C₂₋₅ alkynyl group is preferably a vinyl group, allyl group, 2-methyl-2-propenyl group, crotonyl group, 2-methyl-2-butenyl group, 3-methyl-2-butenyl group, 2,3-dimethyl-2-butenyl group, ethynyl group, or 2-propargyl group. From the viewpoints of enhancing sensitivity during exposure and promoting radical polymerization during heating at low temperature, a vinyl group or an allyl group is more preferable.

From the viewpoint of enhancing heat resistance, all or part of the component (A) is preferably one or more resins selected from the group consisting of a polyimide precursor (A-1) (hereinafter referred to as the "component (A-1)" in some cases), a polyimide (A-2) (hereinafter referred to as the "component (A-2)" in some cases), a polybenzoxazole precursor (A-3) (hereinafter referred to as the "component (A-3)" in some cases), a polybenzoxazole (A-4) (hereinafter referred to as the "component (A-4)" in some cases), and copolymers thereof.

From the viewpoints of enhancing solubility, enhancing adhesion achieved between the cured film and a metal material, in particular copper, after baking and through interaction with the below-described component (C), and enhancing heat resistance, it is preferable that one or more resins selected from the group consisting of the component (A-1), the component (A-2), the component (A-3), the component (A-4), and copolymers thereof contain a phenolic hydroxyl group.

### <Polyimide precursor (A-1) and Polyimide (A-2)>

Examples of the component (A-1) include components obtained by allowing a tetracarboxylic acid or a derivative thereof such as a tetracarboxylic acid or a corresponding tetracarboxylic dianhydride or tetracarboxylic acid diester dichloride to react with a diamine or a derivative thereof such as a diamine or a corresponding diisocyanate compound or trimethylsilylated diamine. Such components have a tetracarboxylic acid residue and a diamine residue. Examples of the component (A-1) include a polyamic acid, polyamic acid ester, polyamic acid amide, and polyisoimide.

A polyimide precursor is known as a chemically curable or thermosetting resin, and is converted into a polyimide by undergoing heat curing at high temperature to cause dehydrative cyclization, thus forming a highly heat-resistant imide bond. A polyimide precursor is a resin the heat resistance of which is enhanced after the dehydrative cyclization. Thus, the polyimide precursor is suitable, for example, for use for applications in which both the properties of the precursor structure before dehydrative cyclization and the heat resistance of the cured film are desired to be achieved.

From the viewpoint of enhancing the heat resistance of the cured film, it is preferable for a photosensitive resin composition according to the present invention that all or part of the component (A) is a polyimide precursor having a repeating structural unit represented by Formula (7), or a copolymer thereof.

In a case where a photosensitive resin composition according to the present invention includes the component (A-2) as the component (A), all or part of the component (A) is preferably a polyimide resin containing a repeating structural unit represented by Formula (11), from the viewpoints of enhancing solubility in a developer, enhancing adhesion to metal, and enhancing migration resistance.

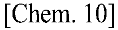

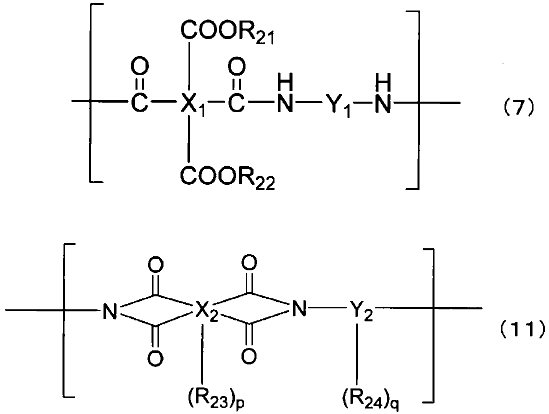

In Formula (7), X₁ is a tetravalent group having a C₂₋₂₀ aliphatic structure, a C₄₋₂₀ alicyclic structure, or a C₄₋₄₀ aromatic structure; Y₁ is a divalent organic group having a C₂₋₂₀ aliphatic structure, a C₄₋₂₀ alicyclic structure, or a C₄₋₄₀ aromatic structure; and R₂₁ and R₂₂ are each independently a hydrogen atom, a C₁₋₂₀ alkyl group, or a monovalent organic group having an ethylene-type unsaturated double bond.

In Formula (11), X₂ is a tetravalent to decavalent group having a C₂₋₂₀ aliphatic structure, a C₄₋₂₀ alicyclic structure, or a C₄₋₄₀ aromatic structure. Y₂ is a divalent to decavalent organic group having a C₂₋₂₀ aliphatic structure, a C₄₋₂₀ alicyclic structure, or a C₄₋₄₀ aromatic structure. R₂₃ and R₂₄ are each independently a phenolic hydroxyl group, a sulfonic acid group, a mercapto group, or a substituent represented by Formula (12) or Formula (13). p is an integer of 0 to 6. q is an integer of 0 to 8.

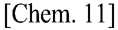

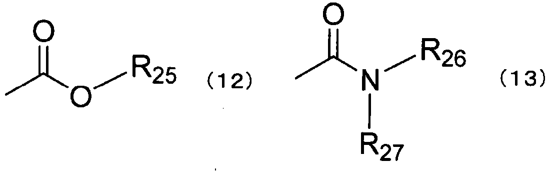

In Formula (12) and Formula (13), R₂₅ to R₂₇ are each independently a hydrogen atom, a C₁₋₁₀ alkyl group, a C₂₋₆ acyl group, or a C₆₋₁₅ aryl group. Among these, a hydrogen atom, a C₁₋₆ alkyl group, a C₂₋₄ acyl group, or a C₆₋₁₀ aryl group is preferable. The alkyl group, acyl group, and aryl group may have a heteroatom, and a hydrogen atom in the group may be substituted with a C₁₋₁₀ alkyl group or a halogen atom.

Assuming that the total of the repeating structural units of all the polyamic acids and the repeating structural units of all the polyamic acid esters in the component (A-1) is 100 mol%, the ratio of the repeating structural units of all the polyamic acid esters in the component (A-1) is defined as an esterification rate of the component (A-1).

The esterification rate can be easily determined by NMR measurement or the like. Specific examples include a method in which the peak intensity derived from the hydrogen atoms of all the aromatic rings in the polyimide precursor is compared with the peak intensity derived from the following: the hydrogen atoms of the hydrocarbons directly bound to the ester groups of all the polyamic acid esters, in the residues of all the tetracarboxylic acids and the derivatives thereof and the residues of all the dicarboxylic acids and the derivatives thereof; or the monovalent organic groups having an ethylene-type unsaturated double bond.

From the viewpoint of enhancing ion migration resistance, the esterification rate of the component (A-1) is preferably 40 mol% or more and 80 mol% or less.

In Formula (7) and Formula (11), X₁ and X₂ are each a tetracarboxylic acid residue, and Y₁ and Y₂ are each a diamine residue.

Specific examples of the residue of a tetracarboxylic acid having an aliphatic structure or a derivative of the tetracarboxylic acid include residues of the following: butanetetracarboxylic acid, ethylene glycol bistrimellitic acid, 4,4'-ethylenebis(2,6-morpholinedione), and meso-butane-1,2,3,4-tetracarboxylic acid; and a tetracarboxylic dianhydride of, a tetracarboxylic dichloride of, and a tetracarboxylic acid active diester of these compounds. One or two or more of these residues may be contained in the molecular structure of the component (A-1).

Specific examples of the residue of a tetracarboxylic acid having an alicyclic structure or a derivative of the tetracarboxylic acid include residues of the following: butanetetracarboxylic acid, 1,2,3,4-cyclobutanetetracarboxylic acid, 1,2,3,4-cyclopentanetetracarboxylic acid, bicyclo[2.2.2]oct-7-ene-2,3,5,6-tetracarboxylic acid, 5-(2,5-dioxotetrahydrofuryl)-3-methyl-3-cyclohexene-1,2-dicarboxylic acid, dicyclohexyl-3,4,3',4'-tetracarboxylic acid, and 4-(2,5-dioxotetrahydrofuran-3-yl)-tetralin-1,2-dicarboxylic acid, octahydrobiphenylene-4a,8b:4b,8a-tetracarboxylic acid, 1,2,4,5-cyclohexanetetracarboxylic acid, 1,2,3,4-tetramethyl-1,2,3,4-cyclobutanetetracarboxylic acid, 3-(carboxymethyl)-1,2,4-cyclopentanetricarboxylic acid, and norbornane-2-spiro-a-cyclopentanone-a' -spiro-2" -norbornane-5,5",6,6"-tetracarboxylic acid; and a tetracarboxylic dianhydride of, a tetracarboxylic dichloride of, and a tetracarboxylic acid active diester of these compounds. One or two or more of these residues may be contained in the molecular structure of the component (A-1).

Specific examples of the residue of a tetracarboxylic acid or a derivative thereof having an aromatic structure include residues of the following: pyromellitic acid, 3,3',4,4'-biphenyltetracarboxylic acid, 2,3,3',4'-biphenyltetracarboxylic acid, 2,2',3,3'-biphenyltetracarboxylic acid, 3,3',4,4'-diphenylethertetracarboxylic acid, 3,3',4,4'-benzophenonetetracarboxylic acid, 2,2',3,3'-benzophenonetetracarboxylic acid, 2,2-bis(3,4-dicarboxyphenyl)propane, 2,2-bis(2,3-dicarboxyphenyl)propane, 1,1-bis(3,4-dicarboxyphenyl)ethane, 1,1-bis(2,3-dicarboxyphenyl)ethane, bis(3,4-dicarboxyphenyl)methane, bis(2,3-dicarboxyphenyl)methane, bis(3,4-dicarboxyphenyl)ether, 1,2,5,6-naphthalenetetracarboxylic acid, 9,9-bis(3,4-dicarboxyphenyl)fluorene, 9,9-bis {4-(3,4-dicarboxyphenoxy)phenyl} fluorene, 2,3,6,7-naphthalenetetracarboxylic acid, 2,3,6,7-naphthalenetetracarboxylic acid, 2,3,5,6-pyridinetetracarboxylic acid, 3,4,9,10-perylenetetracarboxylic acid, 2,2-bis(3,4-dicarboxyphenyl)hexafluoropropane, and aromatic tetracarboxylic acid having the below-described structure; and a tetracarboxylic dianhydride of, a tetracarboxylic dichloride of, and a tetracarboxylic acid active diester of these compounds. One or two or more of these residues may be contained in the molecular structure of the component (A-1).

In addition, the tetracarboxylic acid residue contained in the molecular structure of the component (A-1) may be a residue containing an amide structure such as of the following Formula.

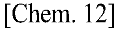

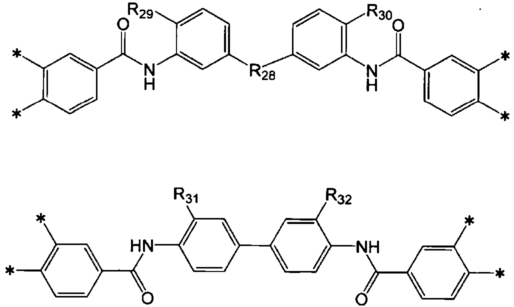

In the Formula, R₂₈ is an oxygen atom, C(CF₃)₂, or C(CH₃)₂. R₂₉ to R₃₂ are each a hydrogen atom or a hydroxyl group. * is a binding site that binds to an amide structure, a carboxylic acid structure, or a carboxylic acid ester structure.

In addition, in a case where R₂₉ to R₃₂ are hydroxyl groups, and where these tetracarboxylic acid residues are introduced into Formula (7), a polyimide precursor capable of further providing a benzoxazole group is obtained by heat curing.

From the viewpoint of enhancing heat resistance, all or part of the structure of X₁ in Formula (7) is preferably a structure represented by Formula (8).

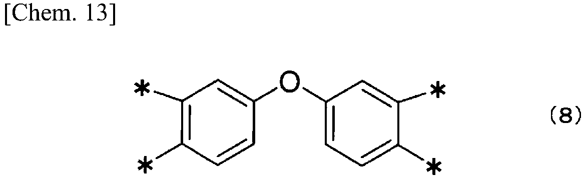

In Formula (8), * is a binding site that binds to an amide structure, a carboxylic acid structure, or a carboxylic acid ester structure.

Specific examples of the residue of a diamine having an aliphatic structure or a derivative of the diamine include residues of the following: ethylenediamine, 1,3-diaminopropane, 2-methyl-1,3-propanediamine, 1,4-diaminobutane, 1,5-diaminopentane, 2-methyl-1,5-diaminopentane, 1,6-diaminohexane, 1,7-diaminoheptane, 1,8-diaminooctane, 1,9-diaminononane, 1,10-diaminodecane, 1,11-diaminoundecane, and 1,12-diaminododecane; and these compounds in which the amine site is isocyanated or trimethylsilylated. One or two or more of these residues may be contained in the molecular structure of the component (A-1).

Specific examples of the residue of a diamine having an alicyclic structure or a derivative of the diamine include residues of the following: bis(aminomethyl)norbornane, 4,4'-methylenebis(cyclohexylamine), 4,4'-diamino-3,3'-dimethyldicyclohexylmethane, 1-amino-3-aminomethyl-3,5,5-trimethylcyclohexane, 1,3-bis(aminomethyl)cyclohexane, 1,4-bis(aminomethyl)cyclohexane, 1,3-cyclohexanediamine, 1,4-cyclohexanediamine; and compounds in which the amine site is isocyanated or trimethylsilylated. One or two or more of these residues may be contained in the molecular structure of the component (A-1).

Specific examples of the residue of a diamine having an aromatic structure or a derivative of the diamine include residues of the following: bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl)ether, bis(3-amino-4-hydroxy)biphenyl, bis(3-amino-4-hydroxyphenyl)fluorene, 3-sulfonic acid-4,4'-diaminodiphenylether, dimercaptophenylenediamine, 3,4'-diaminodiphenylether, 4,4'-diaminodiphenylether, 3,4'-diaminodiphenylmethane, 4,4'-diaminodiphenylmethane, 3,4'-diaminodiphenylsulfone, 4,4'-diaminodiphenylsulfone, 3,4'-diaminodiphenylsulfide, 4,4'-diaminodiphenylsulfide, 1,4-bis(4-aminophenoxy)benzene, benzine, m-phenylenediamine, p-phenylenediamine, 1,5-naphthalenediamine, 2,6-naphthalenediamine, bis(4-aminophenoxyphenyl) sulfone, bis(3-aminophenoxyphenyl) sulfone, bis(4-aminophenoxy)biphenyl, bis {4-(4-aminophenoxy)phenyl} ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, 2,4-diamino-1,3,5-triazine (guanamine), 2,4-diamino-6-methyl-1,3,5-triazine (acetoguanamine), 2,4-diamino-6-phenyl-1,3,5-triazine (benzoguanamine), 2,2'-bis(trifluoromethyl)-4,4'-diaminobiphenyl, 2,2-bis(4-aminophenyl)hexafluoropropane; and compounds in which the amine site thereof is isocyanated or trimethylsilylated. One or two or more of these residues may be contained in the molecular structure of the component (A-1).

Specific examples of the residue of a diamine having a phenolic hydroxyl group or a derivative of the diamine include, but are not limited to, residues of 2,2-bis(3-amino-4-hydroxyphenyl)hexafluoropropane, 2,2-bis[3-(3-aminobenzamide)-4-hydroxyphenyl]hexafluoropropane, bis(3-amino-4-hydroxyphenyl)ether, bis(3-amino-4-hydroxyphenyl)methylene, bis[N-(3-aminobenzoyl)-3-amino-4-hydroxyphenyl] sulfone, bis[*N*-(4-aminobenzoyl)-3-amino-4-hydroxyphenyl] sulfone, bis(3-amino-4-hydroxyphenyl)sulfone, bis(3-amino-4-hydroxyphenyl)propane, 2,2'-bis[*N*-(3-aminobenzoyl)-3-amino-4-hydroxyphenyl]propane, 2,2'-bis[*N*-(4-aminobenzoyl)-3-amino-4-hydroxyphenyl]propane, 9,9-bis(3-amino-4-hydroxyphenyl)fluorene, 9,9-bis[*N*-(3-aminobenzoyl)-3-amino-4-hydroxyphenyl]fluorene, 9,9-bis[*N*-(4-aminobenzoyl)-3-amino-4-hydroxyphenyl]fluorene, *N*,*N*'-bis(3-aminobenzoyl)-2,5-diamino-1,4-dihydroxybenzene, *N*,*N*'-bis(4-aminobenzoyl)-2,5-diamino-1,4-dihydroxybenzene, *N*,*N*'-bis(4-aminobenzoyl)-4,4'-diamino-3,3-dihydroxybiphenyl, *N*,*N*'-bis(3-aminobenzoyl)-3,3'-diamino-4,4-dihydroxybiphenyl, *N*,*N*'-bis(4-aminobenzoyl)-3,3'-diamino-4,4-dihydroxybiphenyl, 3,3'-diamino-4,4'-biphenol, bis(3-amino-4-hydroxyphenyl)methane, 1,1-bis(3-amino-4-hydroxyphenyl)ethane, 2,2-bis(3-amino-4-hydroxyphenyl)propane, and 1,3-bis(4-amino-3-hydroxyphenoxy)benzene. One or two or more of these residues may be used in the component (A-1).

In addition, the diamine residue contained in the molecular structure of the component (A-1) may be a residue containing an amide structure such as of the following Formula.

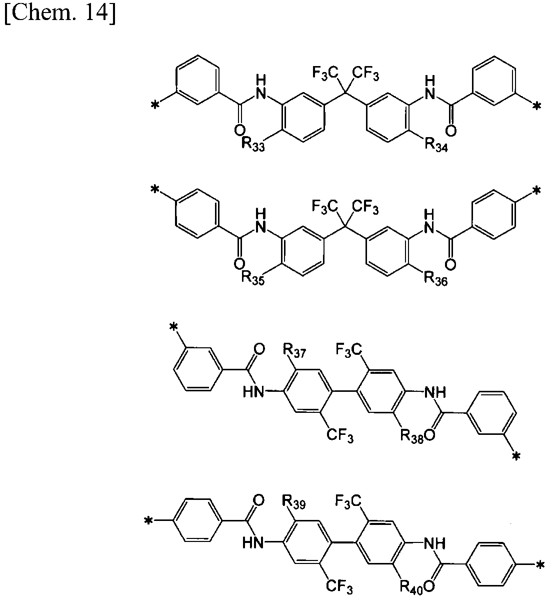

* is a binding site that binds to an amide structure.

In the Formula, R₃₃ to R₄₀ are each a hydrogen atom or a hydroxyl group.

In addition, in a case where R₃₃ to R₄₀ in the Formula are hydroxyl groups, and where these diamine residues are introduced into Formula (7), a polyimide precursor capable of further providing a benzoxazole group is obtained by heat curing.

From the viewpoint of enhancing heat resistance and sensitivity, it is preferable that all or part of the component (A) is a polyimide precursor containing a repeating structural unit represented by Formula (7) or a copolymer of the polyimide precursor, and that, assuming that the amount of the repeating structural unit represented by Formula (7) is 100 mol%, the repeating structural unit in which Y₁ has a structure represented by Formula (14) accounts for 70 mol% or more and 100 mol% or less of the amount.

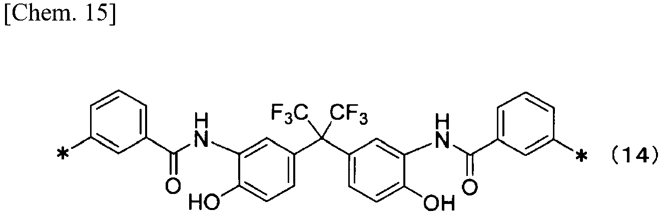

In Formula (14), * is a binding site that binds to an amide structure.

In addition, in Formula (7), all or part of R₂₁ and R₂₂ are preferably monovalent organic groups having an ethylene-type unsaturated double bond of the following Formula (15) or Formula (16). The introduction of an ethylene-type unsaturated double bond makes it possible to enhance sensitivity.

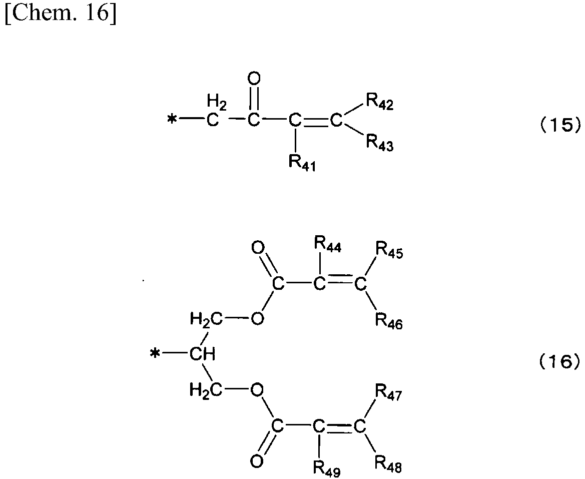

In Formula (15), R₄₁ is a hydrogen atom or a methyl group. R₄₂ and R₄₃ are each independently a hydrogen atom or a C₁₋₃ organic group. * is a binding site.

In Formula (16), R₄₄ and R₄₉ are each a hydrogen atom or a methyl group. R₄₅ to R₄₈ are each independently a hydrogen atom or a C₁₋₃ organic group. * is a binding site.

### <Polybenzoxazole precursor (A-3) and Polybenzoxazole (A-4)>

Examples of the component (A-3) include components obtained by allowing a dicarboxylic acid, a corresponding dicarboxylic dichloride, a dicarboxylic acid active diester, or the like to react with a bisaminophenol compound or the like as a diamine. Such components have a dicarboxylic acid residue and a bisaminophenol compound residue. Examples of the component (A-3) include poly-α-hydroxyamide.

The component (A-3) is a thermosetting resin. When heat-cured at high temperature to undergo dehydrative cyclization, the component results in having a highly heat-resistant, rigid benzoxazole ring formed therein, thus yielding the polybenzoxazole (A-4). Accordingly, allowing the photosensitive resin composition to contain the component (A-3) makes it possible to enhance the heat resistance of the resulting cured film markedly. Hence, the cured film is suitable, for example, for use for applications in which high heat resistance is desired. In addition, the component (A-3) is a resin the heat resistance of which is enhanced after the dehydrative cyclization. Thus, the component (A-3) is suitable, for example, for use for applications in which both the properties of the precursor structure before dehydrative cyclization and the heat resistance of the cured film are desired to be achieved.

From the viewpoint of enhancing the heat resistance and i-line transmittance of the cured film, the component (A) preferably contains a repeating structural unit represented by Formula (17).

In a case where a photosensitive resin composition according to the present invention includes the component (A-4), the component (A) preferably contains a repeating structural unit represented by Formula (18), from the viewpoints of enhancing solubility in a developer, enhancing adhesion to metal, and enhancing migration resistance.

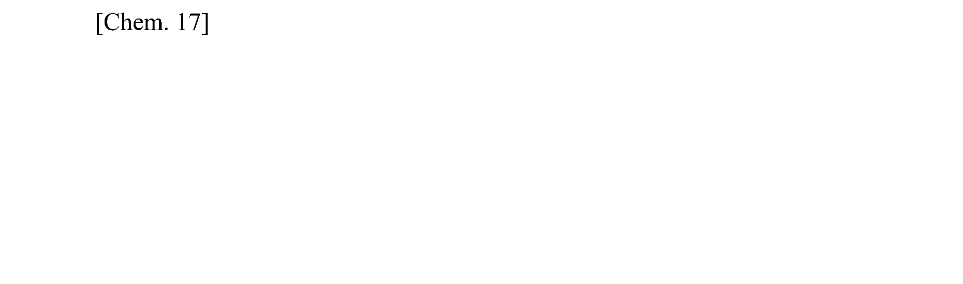

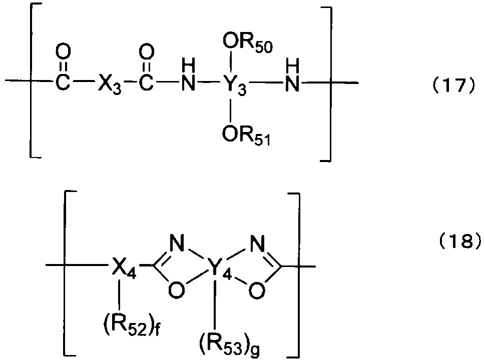

In Formula (17), X₃ is a divalent organic group having a C₂₋₂₀ aliphatic structure, a C₄₋₂₀ alicyclic structure, or a C₄₋₄₀ aromatic structure. Y₃ is a tetravalent organic group having a C₂₋₂₀ aliphatic structure, a C₄₋₂₀ alicyclic structure, or a C₄₋₄₀ aromatic structure.

R₅₀ and R₅₁ are each independently a hydrogen atom, a C₁₋₂₀ monovalent alkyl group, or a monovalent organic group having an ethylene-type unsaturated double bond.

In Formula (18), X₄ is a divalent to decavalent organic group having a C₂₋₂₀ aliphatic structure, a C₄₋₂₀ alicyclic structure, or a C₄₋₄₀ aromatic structure. Y₄ is a tetravalent to decavalent organic group having a C₂₋₂₀ aliphatic structure, a C₄₋₂₀ alicyclic structure, or a C₄₋₄₀ aromatic structure. R₅₂ and R₅₃ are each independently a phenolic hydroxyl group, a sulfonic acid group, a mercapto group, or a substituent represented by Formula (12) or Formula (13) above. f is an integer of 0 to 8. g is an integer of 0 to 6.

In Formula (17) and Formula (18), X₃ and X₄ are each a dicarboxylic acid residue, and Y₃ and Y₄ are each a bisaminophenol residue. Examples of dicarboxylic acid derivatives that provide dicarboxylic acid residues include dicarboxylic anhydrides, dicarboxylic acid chlorides, and dicarboxylic acid active esters.

Specific examples of dicarboxylic acids or derivatives thereof include terephthalic acid, isophthalic acid, diphenyl ether dicarboxylic acid, bis(carboxyphenyl)hexafluoropropane, biphenyldicarboxylic acid, benzophenone dicarboxylic acid, triphenyldicarboxylic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, and triacontanedioic acid. One or two or more of these residues may be contained in the molecular structure of the component (A-3).

From the viewpoint of enhancing heat resistance and sensitivity, it is preferable for a photosensitive resin composition according to the present invention that all or part of the structure of each of X₃ and X₄ in Formula (17) and Formula (18) is a structure represented by Formula (19).

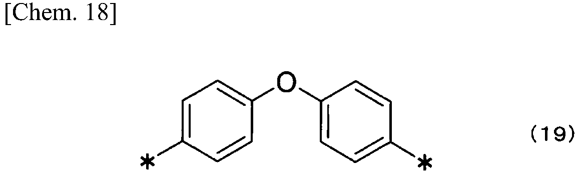

In Formula (19), * is a binding site that binds to an amide structure.

Specific examples of residues of bisaminophenol compounds or derivatives thereof include, but are not limited to, residues of 2,2-bis(3-amino-4-hydroxyphenyl)hexafluoropropane, 2,2-bis[3-(3-aminobenzamide)-4-hydroxyphenyl]hexafluoropropane, bis(3-amino-4-hydroxyphenyl)ether, bis(3-amino-4-hydroxyphenyl)methylene, bis[*N*-(3-aminobenzoyl)-3-amino-4-hydroxyphenyl] sulfone, bis[*N*-(4-aminobenzoyl)-3-amino-4-hydroxyphenyl] sulfone, bis(3-amino-4-hydroxyphenyl)sulfone, bis(3-amino-4-hydroxyphenyl)propane, 2,2'-bis[*N*-(3-aminobenzoyl)-3-amino-4-hydroxyphenyl]propane, 2,2'-bis[*N*-(4-aminobenzoyl)-3-amino-4-hydroxyphenyl]propane, 9,9-bis(3-amino-4-hydroxyphenyl)fluorene, 9,9-bis[*N*-(3-aminobenzoyl)-3-amino-4-hydroxyphenyl]fluorene, 9,9-bis[*N*-(4-aminobenzoyl)-3-amino-4-hydroxyphenyl]fluorene, *N,N*'-bis(3-aminobenzoyl)-2,5-diamino-1,4-dihydroxybenzene, *N,N*'-bis(4-aminobenzoyl)-2,5-diamino-1,4-dihydroxybenzene, *N,N*'-bis(4-aminobenzoyl)-4,4'-diamino-3,3-dihydroxybiphenyl, *N,N*'-bis(3-aminobenzoyl)-3,3'-diamino-4,4-dihydroxybiphenyl, *N,N*'-bis(4-aminobenzoyl)-3,3'-diamino-4,4-dihydroxybiphenyl, 3,3'-diamino-4,4'-biphenol, bis(3-amino-4-hydroxyphenyl)methane, 1,1-bis(3-amino-4-hydroxyphenyl)ethane, 2,2-bis(3-amino-4-hydroxyphenyl)propane, and 1,3-bis(4-amino-3-hydroxyphenoxy)benzene. One or two or more of these residues may be contained in the component (A-3).

In addition, in Formula (18), R₅₀ and R₅₁ preferably contain an ethylene-type unsaturated double bond of Formula (20). Introducing an ethylene-type unsaturated double bond into Formula (18) enables the sensitivity to be enhanced.

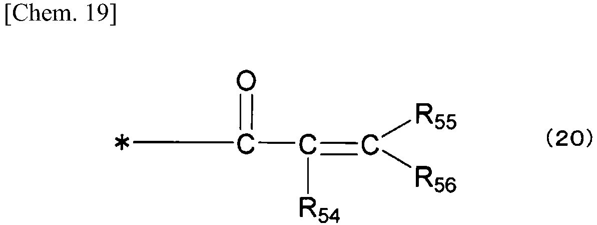

In Formula (20), R₅₄ is a hydrogen atom or a methyl group. R₅₅ and R₅₆ are each independently a hydrogen atom or a C₁₋₃ organic group. * is a binding site.

### <Photosensitizer (B) (Component (B))>

The photosensitizer (B) used for a photosensitive resin composition according to the present invention is a compound that undergoes bond cleavage, reaction, or structural change through exposure to light to generate another compound, thereby imparting positive or negative photosensitivity to the resin composition, or imparting a positive or negative latent image forming capability to the resin composition.

The photosensitizer (B) to be used is preferably one or more selected from the group consisting of a photopolymerization initiator (B1), naphthoquinone diazide compound (B2), photoacid generator (B3), and photobase generator (B4). In a case where negative photosensitivity is to be imparted to the composition, it is preferable to use a photopolymerization initiator (B1), and it is more preferable to use one or more selected from the group consisting of a naphthoquinone diazide compound (B2), photoacid generator (B3), and photobase generator (B4). In a case where positive photosensitivity is to be imparted to the composition, it is preferable to use a naphthoquinone diazide compound (B2), and it is more preferable to use one or more selected from the group consisting of a photopolymerization initiator (B1), photoacid generator (B3), and photobase generator (B4).

In a photosensitive resin composition according to the present invention, the amount of the component (B) is preferably 1.0 part by mass or more, more preferably 3.0 parts by mass or more, still more preferably 5.0 parts by mass or more, with respect to 100 parts by mass of the component (A), from the viewpoint of enhancing sensitivity during exposure. On the other hand, the amount of the component (B) is preferably 30 parts by mass or less, more preferably 25 parts by mass or less, still more preferably 20 parts by mass or less, with respect to 100 parts by mass of the component (A), from the viewpoint of restraining residues after development.

### <Photopolymerization initiator (B1)>

The photopolymerization initiator (B1) (hereinafter referred to as the "component (B1)" in some cases) refers to a compound that undergoes bond cleavage and/or reaction through exposure to light to generate a radical. The inclusion of the component (B1) is suitable for forming a negative pattern, and brings about the marked effect of enhancing sensitivity during exposure. The component (B1) is preferably an α-hydroxyketone compound, α-aminoketone compound, biimidazole compound, acylphosphine oxide compound, or oxime ester compound. The preferable amount of each of these components (B) is the same as described above.

From the viewpoint of enhancing sensitivity during exposure, all or part of the component (B) is preferably an oxime ester compound (B1-1) (hereinafter referred to as the "compound (B1-1)" in some cases). The oxime ester structure contained in the compound (B1-1) undergoes bond cleavage and/or reaction through exposure to light to generate a radical.

Examples of the compound (B1-1) include 1-phenylpropane-1,2-dione-2-(*O-*ethoxycarbonyl)oxime, 1-phenylbutane-1,2-dione-2-(*O*-methoxycarbonyl)oxime, 1,3-diphenylpropane-1,2,3-trione-2-(*O*-ethoxycarbonyl)oxime, 1-[4-(phenylthio)phenyl]octane-1,2-dione-2-(*O*-benzoyl)oxime, 1-[4-[4-carboxyphenylthio]phenyl]propane-1,2-dione-2-(*O*-acetyl)oxime, 1-[4-[4-(2-hydroxyethoxy)phenylthio]phenyl]propane-1,2-dione-2-(*O*-acetyl)oxime, 1-[4-(phenylthio)phenyl]-3-cyclopentylpropane-1,2-dione-2-(*O*-benzoyl)oxime, 1-[4-(phenylthio)phenyl]-2-cyclopentylethane-1,2-dione-2-(*O*-acetyl)oxime, 1-[9,9-diethylfluorene-2-yl]propane-1,2-dione-2-(*O*-acetyl)oxime, 1-[9,9-di-n-propyl-7-(2-methylbenzoyl)-fluorene-2-yl]ethanone-1-(*O*-acetyl)oxime, 1-[9-ethyl-6-(2-methylbenzoyl)-9*H*-carbazole-3-yl]ethanone-1-(*O*-acetyl)oxime, 1-[9-ethyl-6-[2-methyl-4-[1-(2,2-dimethyl-1,3-dioxolane-4-yl)methyloxy]benzoyl]-9*H*-carbazole-3-yl]ethanone-1-(*O*-acetyl)oxime, 1-[9-ethyl-6-(2-methylbenzoyl)-9*H*-carbazole-3-yl]-3-cyclopentylpropane-1-one-1-(*O*-acetyl)oxime, and 1-(9-ethyl-6-nitro-9*H-*carbazole-3-yl)-1-[2-methyl-4-(1-methoxypropane-2-yloxy)phenyl]methanone-1-(*O-*acetyl)oxime.

From the viewpoint of having a photobleaching property, the compound (B1-1) preferably has a fluorene structure, benzofluorene structure, dibenzofluorene structure, indole structure, benzoindole structure, phenothiazine structure, phenothiazine oxide structure, or diphenyl sulfide structure. Even in a case where the compound does not have any of these structures, it is also preferable that the compound has a structure in which at least one oxime ester carbonyl structure is bound to a fused polycyclic structure, fused polycyclic heterocyclic structure, or benzene structure. The compound (B1-1) having a photobleaching property brings about the marked effect of enhancing sensitivity during exposure and enhancing the pattern processability of a thick film. In addition, it is presumed that the reduction in the low-molecular-weight components derived from the compound (B1-1) in the cured product restricts ion migration and electromigration, thus enhancing the migration resistance. In this regard, the photobleaching property refers to causing a decrease in absorbance at wavelengths in the ultraviolet region (for example, 400 nm or less) and/or absorbance at wavelengths of visible light (380 to 780 nm) by undergoing bond cleavage and/or reaction through exposure to light.

From the viewpoint of enhancing sensitivity during exposure and pattern processability of a thick film, it is particularly preferable that the compound (B1-1) is a compound having a structure represented by Formula (21). Having a structure represented by Formula (21) makes it possible to inhibit undercut even in thick film processing, without a decrease in the transmittance of the i-line (the wavelength, 365 nm) during photopolymerization.

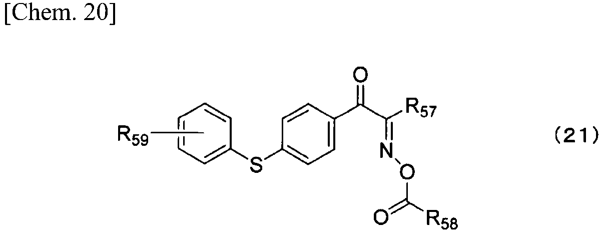

In Formula (21), R₅₇ and R₅₈ are each independently a C₁₋₁₂ alkyl group, C₄₋₁₀ cycloalkyl group, phenyl group, or tolyl group, and R₅₉ is a hydrogen atom, C₁₋₅ alkyl group, -OH, -COOH, -O(CH₂)OH, -O(CH₂)₂OH, -COO(CH₂)OH, or - COO(CH₂)₂OH.

Examples of the compound (B1-1) having a structure represented by Formula (21) include NCI-930 (tradename, manufactured by ADEKA Corporation) and some compounds described in WO2015/036910.

From the viewpoint of enhancing sensitivity during exposure, all or part of the component (B) is preferably a phosphine oxide compound (B1-2) (hereinafter referred to as the "compound (B1-2)" in some cases). (B1-2) has a phosphine oxide structure in the molecule, and undergoes bond cleavage and/or reaction through exposure to light to generate a radical. In addition, the compound (B1-2) is preferably a compound having an acyl group in the molecule.

Examples of the compound (B1-2) include 2,4,6-trimethylbenzoyldiphenylphosphine oxide, bis(2,4,6-trimethylbenzoyl)-phenylphosphine oxide, and bis(2,6-dimethoxybenzoyl)-(2,4,4-trimethylpentyl)phosphine oxide.

### <Naphthoquinone diazide compound (B2)>

The naphthoquinone diazide compound (B2) refers to a compound that undergoes a structural change through exposure to light to generate indenecarboxylic acid or sulfoindenecarboxylic acid. The inclusion of the naphthoquinone diazide compound (B2) is suitable for forming a positive pattern. The naphthoquinone diazide compound (B2) used in the present invention is preferably a 5-naphthoquinone diazide sulfonic acid ester of, or a 4-naphthoquinone diazide sulfonic acid ester of, a compound having a phenolic hydroxyl group. One or a plurality of kinds of naphthoquinone diazide compounds (B2) may be used.

### <Photoacid generator (B3)>

The photoacid generator (B3) refers to a compound that undergoes bond cleavage and/or reaction through exposure to light to generate an acid. The inclusion of the photoacid generator (B3) is suitable for forming a negative pattern from the viewpoint of promoting cationic polymerization and the like. On the other hand, in a case where the resin or the like has an acidic group protected by an acid-dissociable group, such a case is suitable for forming a positive pattern from the viewpoint of releasing an alkali-soluble group through exposure to light. Examples of the photoacid generator (B3) include ionic compounds or nonionic compounds. As the ionic compound, a triorganosulfonium salt compound is preferably used. As the nonionic compound, a halogen-containing compound, diazomethane compound, sulfone compound, sulfonic acid ester compound, carboxylic acid ester compound, sulfonimide compound, phosphoric acid ester compound, or sulfonebenzotriazole compound is preferably used. One or a plurality of kinds of photoacid generators (B3) may be used.

### <Photobase generator (B4)>

The photobase generator (B4) refers to a compound that undergoes bond cleavage and/or reaction through exposure to light to generate a base. From the viewpoint of promoting anionic polymerization and the like, the inclusion of a photobase generator (B4) is suitable for forming a negative pattern. On the other hand, in a case where the resin or the like has an acidic group protected by base dissociation, such a case is suitable for forming a positive pattern, from the viewpoint of releasing an alkali-soluble group through exposure to light. Examples of the photobase generator (B4) include ionic compounds or nonionic compounds. As the ionic compound, a diazabicycloalkene salt compound, triazabicycloalkene salt compound, α-keto quaternary ammonium salt compound, benzyl quaternary ammonium salt compound, guanidine salt compound, or biguanide salt compound is preferably used. The ionic compound preferably has a ketoprofen structure, oxoxanthene structure, benzofuran structure, or naphthalene structure. As the nonionic compound, a nitrobenzyl carbamate compound, anthracenyl carbamate compound, benzoin carbamate compound, anthraquinone carbamate compound, hydroxycinnamamide compound, or coumarinamide compound is preferably used. One or a plurality of kinds of photobase generators (B4) may be used.

### <Compound (C) represented by Formula (1) (Component (C))>

A photosensitive resin composition according to the present invention contains the component (C).

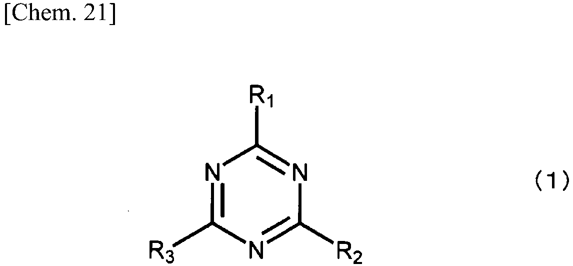

R₁ to R₃ are each independently a hydrogen atom, NR₄R₅, or L(R₆)ₛ. L is a C₆₋₁₀ n-valent organic group having an aromatic ring, R₄ and R₅ are each independently a hydrogen atom, -CH₂OH, -CH₂OCH₃, -CH₂OCH₂CH₂CH₂CH₃, or - CH₂OCH(CH₃)₂, and R₆ is independently -CH₂OH, -CH₂OCH₃, - CH₂OCH₂CH₂CH₂CH₃, or -CH₂OCH(CH₃)₂. n is an integer of 1 to 3, s is an integer of 0 to 2, and n-s is 1.

The inclusion of the component (C) can markedly enhance the adhesion between the cured film and a metal material, in particular copper, after baking. This is due to the interaction between the nitrogen portion of the compound represented by Formula (1) and the surface of the metal. This makes it possible to impart photosensitivity to the resin composition and to obtain a cured resin film that has excellent adhesion to a metal material even in a case where the resin composition contains an additive.

Examples of the component (C) include, but are not limited to, compounds having the following structure.

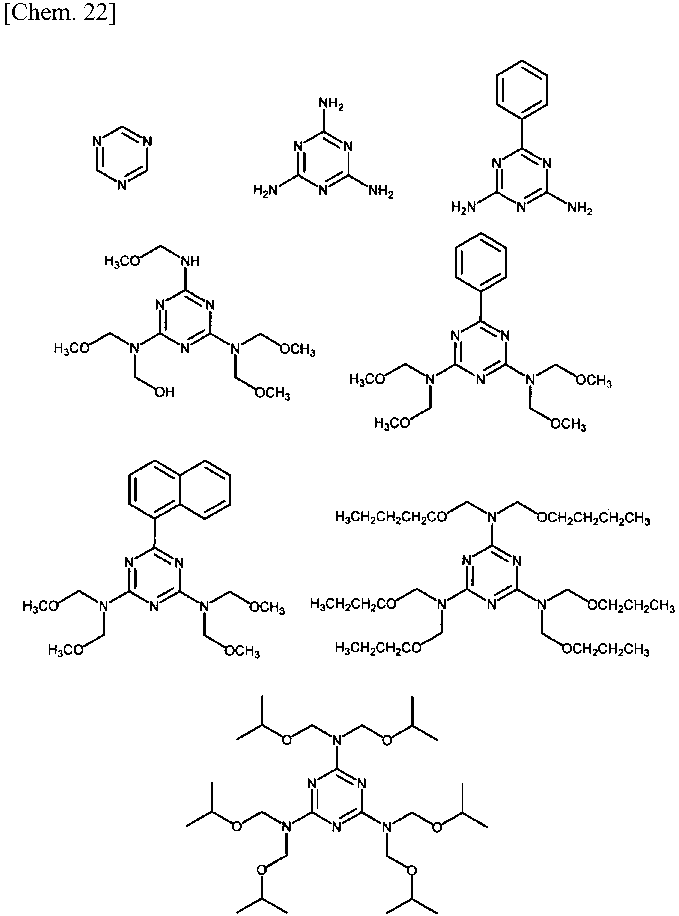

The amount of the component (C) contained in a photosensitive resin composition according to the present invention is preferably 30 parts by mass or more and 1200 parts by mass or less with respect to 100 parts by mass of the below-described component (D).

From the viewpoint of enhancing heat resistance and adhesion to a copper substrate, all or part of the component (C) is preferably a compound having the structure represented by Formula (3).

Examples of compounds having the structure represented by Formula (3) include "NIKALAC" (registered trademark) MW-100LM and MW-390 (both manufactured by Sanwa Chemical Co., Ltd.).

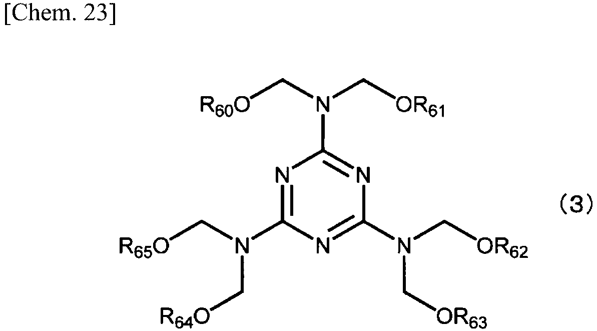

(R₆₀ to R₆₅ are each independently a hydrogen atom, -CH₃, -CH₂CH₂CH₂CH₃, or -CH(CH₃)₂.)

### <Compound (D) represented by Formula (2) (Component (D))>

A photosensitive resin composition according to the present invention contains the component (D).

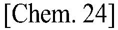

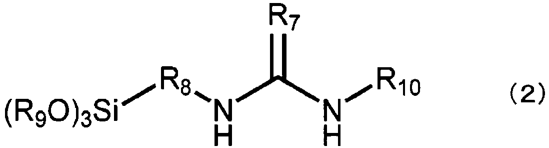

R₇ is an oxygen atom or a sulfur atom. R₈ is a C₁₋₄ divalent organic group, and R₉ is a methyl group or an ethyl group. R₁₀ is a C₁₋₁₈ monovalent hydrocarbon group or a C₆₋₁₂ monovalent aromatic group. Here, the C₁₋₁₈ monovalent hydrocarbon group and the C₆₋₁₂ monovalent aromatic group may contain a heteroatom.

The inclusion of the component (D) can markedly enhance the adhesion between the cured film and a metal material, in particular copper, after baking. This is due to the interaction between the nitrogen portion of the compound represented by Formula (2) and the surface of the metal, and due to the urea structure having a three-dimensional structure that facilitates the interaction with the metal surface. These effects make it possible to impart photosensitivity to the resin composition and to obtain a cured resin film that has excellent adhesion to a metal material even in a case where the resin composition contains an additive.

Examples of the urea compound having an alkoxysilyl group include, but are not limited to, compounds having the following structure.

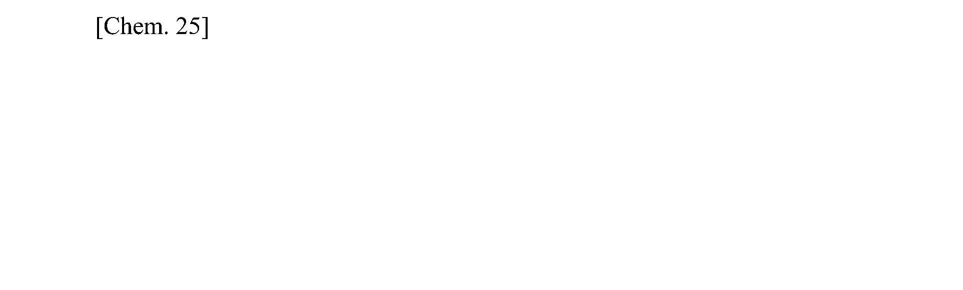

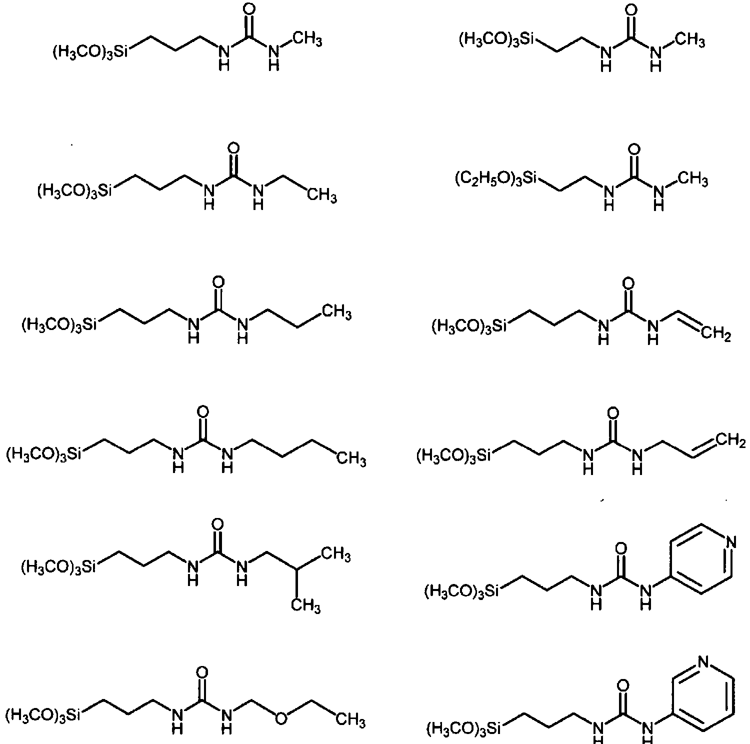

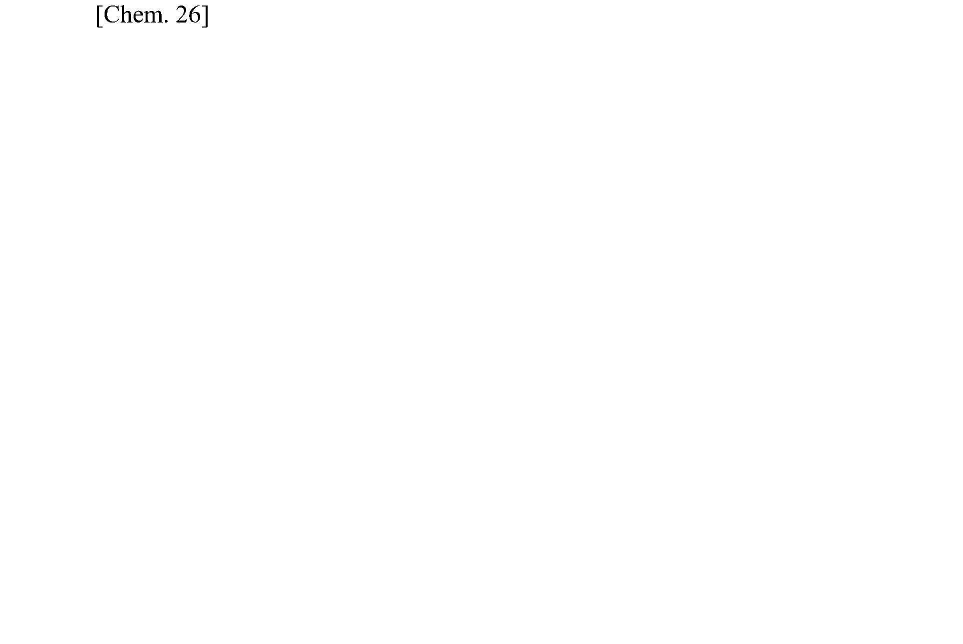

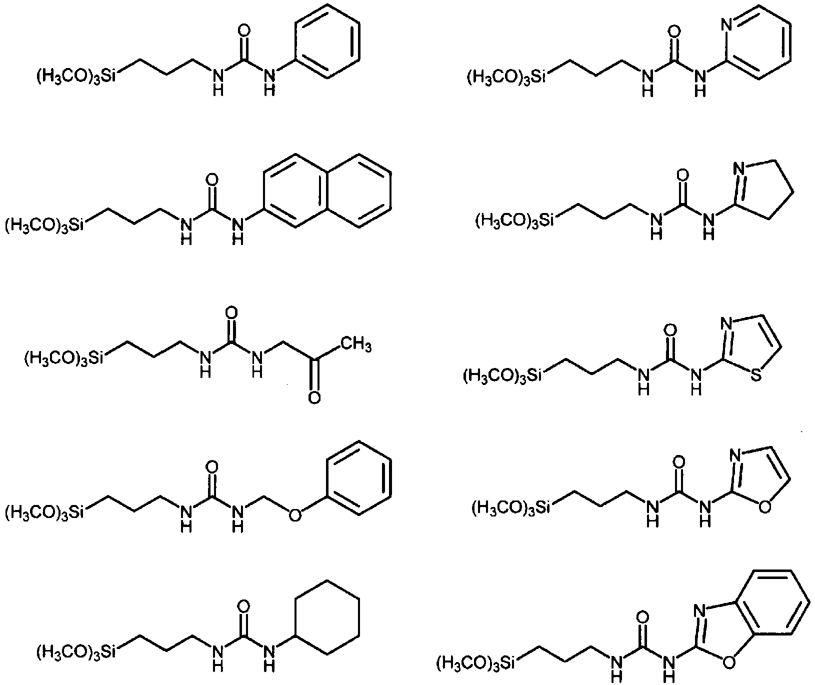

The amount of the component (D) is preferably 0.01 to 5.0 parts by mass, more preferably 0.1 to 5.0 parts by mass, with respect to 100 parts by mass of the component (A). Allowing the amount to be less than 0.1 parts by mass makes it more difficult to obtain the effect of enhancing the adhesion to a metal material. In addition, allowing the amount to be more than 5.0 parts by mass can cause the basicity to affect the photosensitizer, thus resulting in a decrease in the sensitivity of the resin composition. The amount of the component (D) is more preferably 0.2 parts by mass or more. In addition, the amount is more preferably 3.0 parts by mass or less.

From the viewpoint of enhancing adhesion between the cured film and the copper substrate after high-temperature heat treatment, all or part of the component (D) is preferably a compound having the structure represented by Formula (4). Use of such a compound can markedly enhance the adhesion between the cured film and a metal material, in particular copper, after baking.

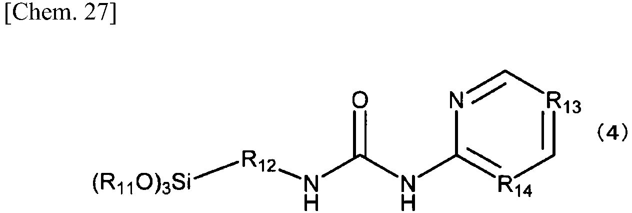

In Formula (4), R₁₁ is a methyl group or an ethyl group. R₁₂ is a C₁₋₄ divalent organic group. R₁₃ and R₁₄ are each independently a carbon atom (i.e., a methine group) or a nitrogen atom. In a photosensitive resin composition according to the present invention, one or a plurality of kinds of components (D) may be used.

### <Other compounds that can be preferably used>

From the viewpoints of promoting the cyclization and curing of the component (A) and enhancing heat resistance, a photosensitive resin composition according to the present invention preferably contains any one or both of a compound represented by Formula (5) and a compound represented by Formula (6).

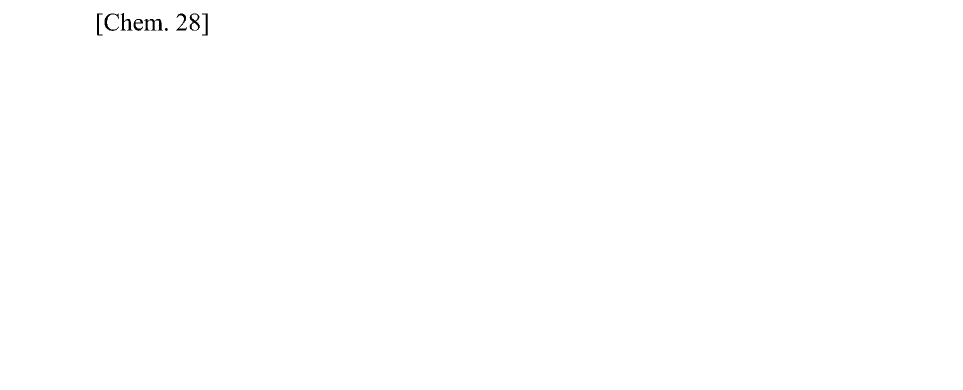

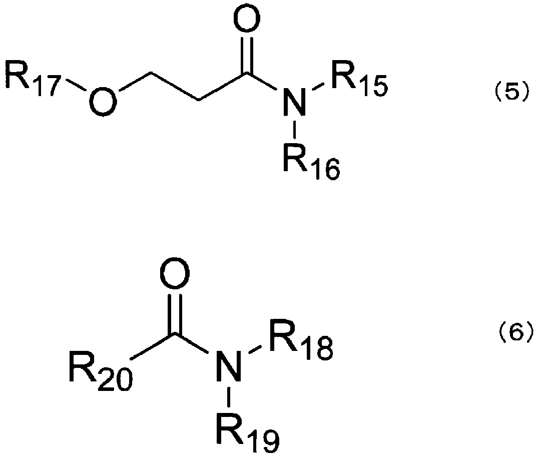

In Formula (5), R₁₅, R₁₆, and R₁₇ are each independently a C₁₋₆ alkyl group. In Formula (6), R₁₈ and R₁₉ are each independently a C₁₋₆ alkyl group. R₂₀ is a hydrogen atom or a C₁₋₆ alkyl group.

The β-alkoxypropionamide that is a compound represented by Formula (5) is preferably 3-methoxy-*N*,*N*-dimethylpropionamide or 3-butoxy-*N,N-*dimethylpropionamide from the viewpoints of enhancing the solubility of the component (A), promoting the cyclization and curing of the component (A), and enhancing heat resistance.

In the present invention, the amount of a compound represented by Formula (5) is preferably 0.1 parts by mass or more, more preferably 1 part by mass or more, with respect to 100 parts by mass of the component (A), from the viewpoints of promoting the cyclization and curing of the component (A), and enhancing heat resistance. On the other hand, from the viewpoint of enabling a developed film to be formed into a desired patterned film, the amount is preferably 15 parts by mass or less, more preferably 7 parts by mass or less.

A compound represented by Formula (6) is preferably *N,N-*dimethylpropionamide or *N,N*-dimethylisobutylamide from the viewpoints of promoting the cyclization and curing of the component (A), and enhancing the heat resistance of the cured film.

In the present invention, the amount of a compound represented by Formula (6) is preferably 0.1 parts by mass or more, more preferably 1 part by mass or more, with respect to 100 parts by mass of the component (A), from the viewpoints of promoting the cyclization and curing of the component (A), and enhancing heat resistance. On the other hand, from the viewpoint of enabling a developed film to be formed into a desired patterned film, the amount is preferably 15 parts by mass or less, more preferably 7 parts by mass or less.

### <Polymerizable compound (E) (Component (E))>

A photosensitive composition according to the present invention contains a polymerizable compound (E) (hereinafter referred to as the "component (E)" in some cases) and/or a crosslinking agent (F). The component (E) refers to a compound having at least two radically polymerizable groups. The radically polymerizable group is preferably an ethylene-type unsaturated double bond group.

It is preferable that a photosensitive composition according to the present invention contains the component (B), and further contains any one or both of the component (E) and the crosslinking agent (F). From the viewpoint of promoting photoreaction, it is more preferable that the composition contains the photopolymerization initiator (B1), and further contains the component (E). In a case where the composition has negative photosensitivity, the inclusion of the component (E) brings about the marked effect of enhancing the sensitivity during exposure. On the other hand, in a case where the composition has positive photosensitivity, the inclusion of the component (E) brings about the marked effect of controlling the pattern shape after heat curing.

The radically polymerizable group contained in the component (E) preferably contains a (meth)acryloyl group from the viewpoint of enhancing sensitivity during exposure. The number of radically polymerizable groups contained in the component (E) is preferably 3 or more, more preferably 4 or more, from the viewpoint of enhancing sensitivity during exposure. On the other hand, the number of radically polymerizable groups is preferably 12 or less, more preferably 10 or less, still more preferably 8 or less, particularly preferably 6 or less, from the viewpoint of enhancing migration resistance.

Examples of the component (E) include: the below-described polyethylene glycol dimethacrylate (E1) represented by Formula (22) (hereinafter referred to as the "component (E1)" in some cases) and polyethylene glycol dimethacrylate (E2) represented by Formula (23) (hereinafter referred to as the "component (E2)" in some cases); and besides these, trimethylolpropane di(meth)acrylate, trimethylolpropane tri(meth)acrylate, ditrimethylolpropane tri(meth)acrylate, ditrimethylolpropane tetra(meth)acrylate, 1,3-butanediol di(meth)acrylate, neopentylglycol di(meth)acrylate, 1,4-butanediol di(meth)acrylate, 1,6-hexanediol di(meth)acrylate, 1,9-nonanediol di(meth)acrylate, 1,10-decanediol di(meth)acrylate, dimethylol-tricyclodecane di(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol hepta(meth)acrylate, tripentaerythritol octa(meth)acrylate, tetrapentaerythritol nona(meth)acrylate, tetrapentaerythritol deca(meth)acrylate, pentapentaerythritol undeca(meth)acrylate, pentapentaerythritol dodeca(meth)acrylate, ethoxylated bisphenol A di(meth)acrylate, 2,2-bis[4-(3-(meth)acryloxy-2-hydroxypropoxy)phenyl] propane, 1,3,5-tris((meth)acryloxyethyl)isocyanuric acid, or 1,3-bis((meth)acryloxyethyl)isocyanuric acid, or acid-modified products thereof.

From the viewpoint of miscibility with the component (A), a (meth)acrylate containing a structure of the following Formula (24) is preferably used. In this regard, "(meth)acrylate" is herein used as a term that encompasses both meanings: an acrylic acid ester and a methacrylic acid ester.

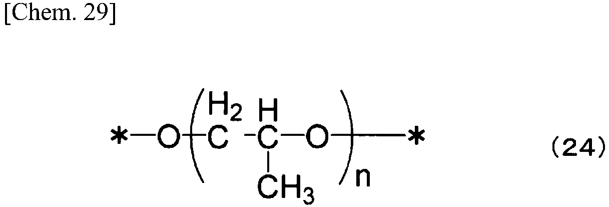

In Formula (24), * is a binding site to a structure derived from a (meth)acrylic acid ester. n is an integer of 1 to 12.

From the viewpoints of preventing elution of exposed portions during development, and further reducing a decrease in film thickness after development, a polymerizable compound of the following Formula (25) is preferably used.

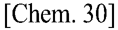

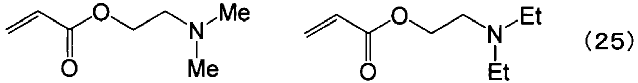

In Formula (25), Me is a methyl group, and Et is an ethyl group.

In a case where a photosensitive composition according to the present invention contains the component (A) and the component (E), the amount of the component (A) is preferably 25 parts by mass or more, more preferably 35 parts by mass or more, still more preferably 45 parts by mass or more, with respect to 100 parts by mass of the total amount of the component (A) and the component (E), from the viewpoint of enhancing sensitivity and enhancing migration resistance. On the other hand, from the viewpoint of enhancing sensitivity during exposure, the amount of the component (A) is preferably 85 parts by mass or less, more preferably 80 parts by mass or less, still more preferably 75 parts by mass or less, with respect to 100 parts by mass of the total amount of the component (A) and the component (E).

In addition, from the viewpoint of enhancing sensitivity during exposure, the amount of the (E) component is preferably 15 parts by mass or more, more preferably 20 parts by mass or more, still more preferably 25 parts by mass or more, with respect to 100 parts by mass of the total amount of the (A) component and the (E) component. On the other hand, from the viewpoint of enhancing migration resistance, the amount of the component (E) is preferably 75 parts by mass or less, more preferably 65 parts by mass or less, still more preferably 55 parts by mass or less, with respect to 100 parts by mass the total amount of the component (A) and the component (E).

### <Component (E1) and Component (E2)>

A photosensitive resin composition according to the present invention further contains polyethylene glycol dimethacrylate (E1) represented by Formula (22) and polyethylene glycol dimethacrylate (E2) represented by Formula (23), and the component (E) preferably contains 4 to 20 parts by mass of the component (E2) with respect to 100 parts by mass of the component (E1). This makes it possible to form a rectangular pattern at a low exposure dose even in thick film processing without reducing the miscibility with the component (A).

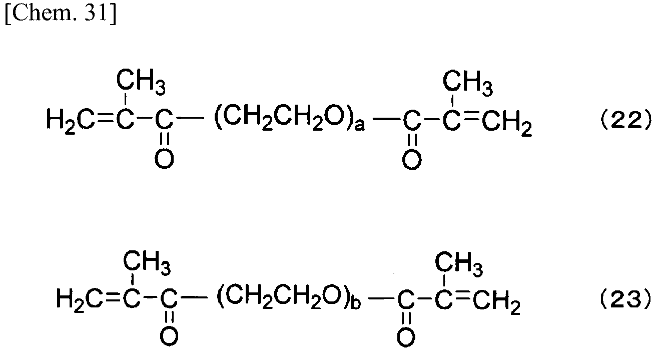

In Formula (22), a is an integer of 4 to 9. In Formula (23), b is an integer of 1 to 3.

Examples of the compound represented by Formula (22) in which a is an integer of 4 to 9 include polyethylene glycol #200 dimethacrylate and polyethylene glycol #400 dimethacrylate.

From the viewpoint of miscibility with component (A), polyethylene glycol #400 dimethacrylate is preferable.

Examples of the compound represented by Formula (23) in which b is an integer of 1 to 3 include ethylene glycol dimethacrylate, diethylene glycol dimethacrylate, and triethylene glycol dimethacrylate. From the viewpoint of enhancing sensitivity, ethylene glycol dimethacrylate is preferable.

### <Crosslinking Agent (F) (Component (F))>

The crosslinking agent (F) (hereinafter referred to as the "component (F)" in some cases) used for a photosensitive composition according to the present invention reacts with the resin (A) to form a crosslinked structure.

It is preferable that a photosensitive composition according to the present invention contains the above-described photosensitizer (B), and further contains the crosslinking agent (F). From the viewpoint of promoting photoreaction, it is more preferable that the composition contains the above-described photoacid generator (B3) or photobase generator (B4), and further contains the crosslinking agent (F). On the other hand, from the viewpoint of enhancing the degree of crosslinking of the resin and the like, it is also preferable that the composition contains the above-described naphthoquinone diazide compound (B2), and further contains the crosslinking agent (F).

From the viewpoint of enhancing sensitivity during exposure, the crosslinking agent (F) is preferably a compound having at least two of one or more kinds of groups selected from the group consisting of an alkoxyalkyl group, hydroxyalkyl group, epoxy group, oxetanyl group, vinyl group, and allyl group (these groups are hereinafter collectively referred to as a "specific crosslinking group" in some cases) (with the proviso that the above components (C) and (E) are excluded). The alkoxyalkyl group is preferably an alkoxymethyl group, more preferably a methoxymethyl group. The hydroxyalkyl group is preferably a methylol group. The number of specific crosslinking groups contained in one molecule of the crosslinking agent (F) is preferably 2 or more, more preferably 3 or more, still more preferably 4 or more, particularly preferably 6 or more, from the viewpoint of enhancing sensitivity during exposure. On the other hand, the number of specific crosslinking groups is preferably 12 or less, more preferably 10 or less, still more preferably 8 or less, from the viewpoint of enhancing mechanical properties in heating at low temperature.

From the viewpoint of enhancing sensitivity during exposure, the amount of the crosslinking agent (F) is preferably 1.0 part by mass or more, more preferably 3.0 parts by mass or more, still more preferably 5.0 parts by mass or more, with respect to 100 parts by mass of the total amount of the component (A) and the component (E) (including the case where the component (E) is not included). On the other hand, from the viewpoint of enhancing heat resistance, the amount of the crosslinking agent (F) is preferably 30 parts by mass or less, more preferably 20 parts by mass or less, with respect to 100 parts by mass of the total amount of the component (A) and the component (E) (including the case where the component (E) is not included). In the present invention, one or a plurality of kinds of crosslinking agents (F) may be used.

### <Component (F1) and Component (F2)>

From the viewpoint of enhancing heat resistance and adhesion to metal wiring, all or part of the crosslinking agent (F) is preferably any one or both of the following components (F1) and (F2).

Component (F1): a compound having at least two phenolic hydroxyl groups and at least two specific crosslinking groups

Component (F2): a compound having a structure including a heteroalicyclic structure and at least two specific crosslinking groups.

The component (F1) is preferably a compound having at least two structures in each of which a phenolic hydroxyl group and a specific crosslinking group are bound to one aromatic ring. In addition, the component (F1) is more preferably a compound having at least two structures in each of which a phenolic hydroxyl group and at least two specific crosslinking groups are bound to one aromatic ring.

The heteroalicyclic structure in the component (F2) is preferably a nitrogen-containing cyclic structure, more preferably a cyclic structure having at least two nitrogen atoms. The cyclic structure having at least two nitrogen atoms is preferably one or more selected from the group consisting of an isocyanuric acid structure, triazine structure, glycoluril structure, imidazolidone structure, pyrazole structure, imidazole structure, triazole structure, tetrazole structure, and purine structure, more preferably contains an isocyanuric acid structure or a triazine structure. The number of nitrogen atoms in the heteroalicyclic structure contained in the compound (F2) is preferably 1 or more, more preferably 2 or more, still more preferably 3 or more. On the other hand, the number of nitrogen atoms is preferably 6 or less, more preferably 4 or less.

### <Other additives>

A photosensitive composition according to the present invention preferably further contains one or more selected from the group consisting of a dissolution promoter, sensitizer, chain transfer agent, polymerization inhibitor, silane coupling agent, and surfactant. As these, known additives may be used.

### <Solvent>

A photosensitive resin composition according to the present invention may contain a solvent. Examples of the solvent include: polar aprotic solvents such as *N*-methyl-2-pyrrolidone, γ-butyrolactone, γ-valerolactone, δ-valerolactone, *N,N-*dimethylformamide, *N,N*-dimethylacetamide, dimethyl sulfoxide, 1,3-dimethyl-2-imidazolidinone, *N,N'*-dimethylpropyleneurea, *N,N-*dimethylisobutyric acid amide, and methoxy-*N,N*-dimethylpropionamide; ethers such as tetrahydrofuran, dioxane, propylene glycol monomethyl ether, and propylene glycol monoethyl ether; ketones such as acetone, methylethyl ketone, and diisobutyl ketone; esters such as ethyl acetate, butyl acetate, isobutyl acetate, propyl acetate, propylene glycol monomethyl ether acetate, and 3-methyl-3-methoxybutyl acetate; alcohols such as ethyl lactate, methyl lactate, diacetone alcohol, and 3-methyl-3-methoxybutanol; and aromatic hydrocarbons such as toluene and xylene. Two or more of these may be contained.

The ratio of the solvent contained in a photosensitive resin composition according to the present invention can be adjusted suitably, depending on the coating method and the like. For example, in a case where a coating film is formed, using spin coating, the ratio is generally 50 to 95 mass% of the whole photosensitive resin composition.

### <Shape of photosensitive resin composition according to the present invention>

A photosensitive resin composition according to the present invention is not limited to any shape, subject to containing the component (A), component (B), component (C), and component (D), and may be, for example, in the form of a paste or a sheet. In addition, a photosensitive sheet according to the present invention refers to a photosensitive resin composition formed into a sheet before being irradiated with actinic rays, and is, for example, a sheet-like product that is obtained by applying a photosensitive resin composition according to the present invention to a support, and drying the composition at a temperature for a time the range of which temperature and the range of which time enable the solvent to volatilize, in which the product is not completely cured, and is soluble in an organic solvent or an alkaline aqueous solution.

The support is not particularly limited, and various commercially available films such as polyethylene terephthalate (PET) films, polyphenylene sulfide films, and polyimide films may be used. The bonding face between the support and the photosensitive resin composition may be surface-treated with silicone, a silane coupling agent, aluminum chelating agent, polyurea, or the like in order to enhance adhesion and peelability. The thickness of the support is not particularly limited, and is preferably in the range of from 10 to 100 µm from the viewpoint of workability. Furthermore, in order to protect the surface of the photosensitive composition film obtained by coating, a protective film may be provided on the surface of the film. This makes it possible to protect the surface of the photosensitive resin composition from pollutants such as dust and dirt in the air.

Examples of methods of applying the photosensitive resin composition to a support include: spin coating with use of a spinner, spray coating, roll coating, and screen printing; and methods with use of a blade coater, die coater, calender coater, meniscus coater, bar coater, roll coater, comma roll coater, gravure coater, screen coater, and slit die coater. In addition, the coating thickness varies depending on the coating method, the solid content concentration and viscosity of the composition, and the like, but it is usually preferable that the coating thickness after drying is 0.5 µm or more and 100 µm or less from the viewpoint of coating uniformity and the like.

For the drying, an oven, hot plate, infrared rays, or the like may be used. The drying temperature and drying time may be within a range that enables the solvent to volatilize, and the range is preferably set suitably so that the photosensitive resin composition can turn into an uncured or semi-cured state. Specifically, the drying is preferably performed at a temperature in the range of from 40°C to 150°C for one minute to tens of minutes. Alternatively, a combination of these temperatures may be applied stepwise in an ascending manner. For example, heat treatment may be performed at 80°C and 90°C for 2 minutes each.

### <Method of producing relief pattern>

A method of producing a relief pattern will be described with reference to a specific example, the method including the steps of: applying a photosensitive resin composition according to the present invention to a substrate, and drying the composition: exposing the composition to light; developing the composition, using an alkaline developer; and heat-treating the composition.

A photosensitive resin composition according to the present invention is applied to a substrate, or the photosensitive sheet is laminated onto a substrate. Without limitation, the substrate may be a copper-plated metal substrate, silicon wafer (silicon substrate), silicon carbide substrate, or gallium nitride substrate, and the material to be used may be ceramics, gallium arsenide, or the like. Examples of coating methods include spin coating with use of a spinner, spray coating, and roll coating. In addition, the coating thickness varies depending on the coating method, the solid content concentration and viscosity of the composition, and the like. The composition is usually applied in such a manner that the coating thickness after drying is 0.1 to 150 µm.

In order to enhance the adhesion between the substrate and the photosensitive resin composition, the substrate may be pretreated with the above-described silane coupling agent. For example, a silane coupling agent is dissolved at 0.5 to 20 mass% in a solvent such as isopropanol, ethanol, methanol, water, tetrahydrofuran, propylene glycol monomethyl ether acetate, propylene glycol monomethyl ether, ethyl lactate, or diethyl adipate. The resulting solution is used for surface treatment through spin coating, immersion, spray coating, vapor treatment, or the like. In some cases, a heat treatment is then performed at 50°C to 300°C to promote the reaction between the substrate and the silane coupling agent.

Next, the substrate to which the photosensitive resin composition has been applied or on which the photosensitive sheet has been laminated is dried to obtain a photosensitive resin composition film. The drying is preferably performed, using an oven, hot plate, infrared rays, or the like at a temperature in the range of from 50°C to 150°C for one minute to several hours. In the case of the photosensitive sheet, the sheet optionally does not undergo the drying step.

Next, the photosensitive resin composition film is exposed to actinic rays through a mask having a desired pattern. Examples of the actinic rays used for exposure include ultraviolet rays, visible light, electron beams, and X-rays. In the present invention, the i-line (the wavelength, 365 nm), h-line (the wavelength, 405 nm), or the g-line (the wavelength, 436 nm) of a mercury lamp is preferably used.

Next, a post-exposure baking treatment is performed. The temperature for this is preferably in the range of from 50 to 180°C, more preferably in the range of from 60 to 150°C. The time is preferably, but not particularly limited to, 10 seconds to several hours, from the viewpoint of developability thereafter.

To form a pattern of the resin, the exposed portion or the unexposed portion is removed, using a developer after the exposure. The developer to be used for development is preferably a good solvent for the photosensitive resin composition or a combination of a good solvent and a poor solvent. For example, in the case of a photosensitive resin composition soluble in an alkaline aqueous solution, the developer to be used for development is a developer that dissolves and removes the alkaline aqueous solution-soluble polymer, and is typically an alkaline aqueous solution in which an alkaline compound is dissolved. Examples of the alkaline compound include tetramethylammonium hydroxide, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, and hexamethylenediamine. In some cases, one material or two or more materials in combination may be added to such an alkaline aqueous solution, examples of which material(s) include: polar solvents such as *N*-methyl-2-pyrrolidone, *N,N*-dimethylformamide, *N,N-*dimethylacetamide, dimethyl sulfoxide, γ-butyrolactone, and dimethylacrylamide; alcohols such as methanol, ethanol, and isopropanol; esters such as ethyl lactate and propylene glycol monomethyl ether acetate; and ketones such as cyclopentanone, cyclohexanone, isobutyl ketone, and methyl isobutyl ketone.

After the development, a rinsing treatment with water is preferably performed. In a case where water is used, the rinsing treatment may be performed with water supplemented with an alcohol such as ethanol or isopropyl alcohol, an ester such as ethyl lactate and propylene glycol monomethyl ether acetate, or the like.

After the development, a temperature of 150°C to 500°C is applied to promote a thermal crosslinking reaction, thereby enhancing heat resistance and chemical resistance. This heat treatment is performed for 5 minutes to 5 hours during which the temperature is raised stepwise over the temperatures selected, or during which the temperature is continuously raised within a certain temperature range selected. For example, the heat treatment is performed at 130°C and 200°C for 30 minutes each. The lower limit of the temperature for curing conditions in the present invention is preferably 170°C or more, more preferably 180°C or more, in order to allow the curing to proceed sufficiently. The upper limit of the temperature for curing conditions is preferably 450°C or less.

### <Cured product of photosensitive resin composition according to the present invention>

A cured product according to the present invention is a cured product obtained by curing the photosensitive resin composition according to the present invention. Here, the "cured product" refers to a product that has been heat-treated at a temperature of 150°C to 500°C for 5 minutes to 5 hours, and has lost film fluidity. That is, a film that does not lose fluidity even after being heat-treated at 500°C for 5 hours does not considered as a cured product.

The cured product can be obtained by applying the photosensitive resin composition to a base material, drying the composition to volatilize the solvent, then performing an exposure step and a post-exposure baking step, if desired, and curing the resulting composition with a temperature of 150°C to 400°C applied thereto. This heat treatment is performed for 5 minutes to 5 hours during which the temperature is raised stepwise over the temperatures selected, or during which the temperature is continuously raised within a certain temperature range selected. For example, the heat treatment is performed at 130°C and 200°C for 30 minutes each. The lower limit of the temperature for curing conditions in the present invention is preferably 170°C or more, more preferably 180°C or more, in order to allow the curing to proceed sufficiently. The upper limit of the temperature for curing conditions is preferably 450°C or less.

### <Compound in cured product>

A cured product according to the present invention contains one or both of a compound having a structure represented by Formula (9) and a compound having a structure represented by Formula (10). These structures are contained in the component (C) or the component (D) in a photosensitive resin composition according to the present invention. In a case where the cured product contains these structures, the nitrogen portion in the compound interacts with the metal surface, thereby making it possible to obtain a cured product having high adhesion to a metal material, particularly to copper. In a case where the component (C) and/or the component (D) in a resin composition according to the present invention reacts or interacts with the component (A) during heat curing, the resulting product results in having a structure represented by Formula (9) or Formula (10) in accordance with the binding mode between the components. Accordingly, a cured product according to the present invention may have only the structure represented by Formula (9), may have only the structure represented by Formula (10), or may have both the structure represented by Formula (9) and the structure represented by Formula (10). In a case where the cured product has the compound having a structure represented by Formula (9) and the compound having a structure represented by Formula (10), the cured product preferably contains the compounds in an amount of 0.01 parts by mass or more and 60 parts by mass or less with respect to 100 parts by mass of the cured film.

These structures in the cured product can be identified by performing nuclear magnetic resonance (¹H-NMR or ¹³C-NMR), infrared absorption spectroscopy (IR), matrix-assisted laser desorption/ionization time-of-flight mass spectrometry (MALDI-TOFMS), or the like on a product obtained by hydrolyzing the cured product with an alkali or the like, or on the cured product itself.

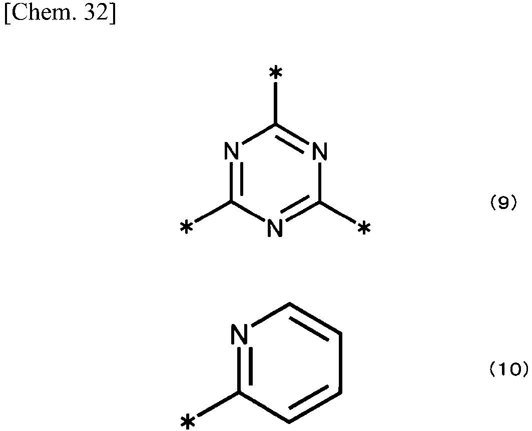

(In Formula (9) and Formula (10), * is a binding site.)

### <Electronic component including cured product>

An electronic component according to the present invention includes a cured product according to the present invention.

A cured product formed from a photosensitive resin composition according to the present invention can be used as an insulating film or a protective film that constitute an electronic component.

Here, examples of electronic components include: such active components having semiconductors as transistors, diodes, integrated circuits (ICs), and memories; and passive components such as resistors, capacitors, and inductors. In addition, an electronic component produced, using a semiconductor is also called a semiconductor device or a semiconductor package.

Specific examples of applications for which the cured product in an electronic component is suitably used include: passivation films for semiconductors; surface protective films for semiconductor elements, TFTs (thin film transistors), and the like; interlayer insulating films such as interlayer insulating films between redistribution lines in 2-layered to 10-layered multilayer wiring for high-density mounting; insulating films and protective films for touch panel displays; and insulating layers for organic electroluminescent devices. The cured product is not limited to these, but can have various structures.

In addition, an electronic component according to the present invention preferably includes a cured product according to the present invention on a substrate. The substrate on the surface of which the cured product is formed may be suitably selected in accordance with the application and process. The substrate is, for example, a silicon substrate, silicon carbide substrate, gallium nitride substrate, ceramics, gallium arsenide, metal, or epoxy resin, preferably a silicon substrate, silicon carbide substrate, or gallium nitride substrate, more preferably a silicon carbide substrate or a gallium nitride substrate.

### Examples

The present invention will be described below with reference to Examples, but the present invention should not be construed as limited to these Examples. First, the evaluation methods used in Examples and Comparative Examples will be described. For the evaluations, a photosensitive resin composition before curing was used, in which the composition had been previously filtered through a polytetrafluoroethylene filter (manufactured by Sumitomo Electric Industries, Ltd.) having an average pore size of 1 µm (the composition is hereinafter referred to as "varnish" in some cases).

### (1) Weight average molecular weight of resin (A)

The weight average molecular weight (Mw) of the resin or the resin solution was measured in terms of polystyrene, using a GPC (gel permeation chromatography) device Waters 2690-996 (manufactured by Waters Corporation Japan), and, using N-methyl-2-pyrrolidone (hereinafter referred to as NMP) as a developing solvent.

### (2) Esterification rate of polyamic acid

Using a nuclear magnetic resonance (NMR) device (EX-270, manufactured by JEOL Ltd.), the ¹H-NMR of a solution mixture of 10 mg of polyamic acid ester and 0.8 g of deuterated dimethyl sulfoxide (DMSO-d6) was measured, and the integral value of the peaks derived from the aromatic protons of the resin was determined. The esterification rate of the polyamic acid ester was calculated from the area ratio to the peaks derived from the methyl protons of the carboxylic acid ester and the ethylene-type unsaturated double bond groups. The resins other than the polyamic acid ester contained no carboxylic acid ester, and hence, the esterification rate was unmeasurable, and is denoted by "-" in Table.

### (3) Evaluation of amount of compound represented by Formula (5) and compound represented by Formula (6) with respect to resin (A)

The resin (A) in an amount of 0.03 g or 0.1 g of a resin solution containing the resin (A) at 30 wt% and 0.01 g of methyl 3-nitrobenzoate as an internal standard substance were dissolved in 0.7 g of deuterated dimethyl sulfoxide. The resulting solution was analyzed by NMR (GX-270, manufactured by JEOL Ltd.). The area of the peak at around 3.9 ppm derived from methyl 3-nitrobenzoate was used as a reference. The amounts [parts by mass] of the compound represented by Formula (5) and the compound represented by Formula (6) with respect to the amount of the resin (A) were measured from the area of each peak.

### (4) Sensitivity

The varnish was applied to an 8-inch silicon wafer by spin coating, using an ACT-8 coating and developing device (Tokyo Electron Ltd.), and prebaked at 100°C for 5 minutes to produce a prebaked film having a thickness of 15.0 µm in the case of a positive photosensitive resin composition. In the case of a negative photosensitive resin composition, a 22.0 µm prebaked film was produced. The film thickness was measured, using a LAMBDA ACE STM-602 manufactured by Dainippon Screen Mfg. Co., Ltd. under conditions at a refractive index of 1.63. Then, using an i-line stepper NSR-2005i9C (Nikon Corporation) that is an exposure device, the film was exposed to light through a mask having a 100 µm, 1:1, line and space pattern at an exposure dose in the range of from 100 to 2000 mJ/cm² at intervals of 50 mJ/cm². In the case of a negative photosensitive resin composition, the composition was baked at 120°C for 1 minute after the exposure. Then, puddle development was performed for 120 seconds, using the ACT-8 developing device, and using a 2.38 mass% tetramethylammonium aqueous solution (hereinafter referred to as "TMAH", manufactured by Tama Chemicals Co., Ltd.) as a developer. Then, the resulting film was rinsed with distilled water and dried by virtue of shaking off to yield a pattern. The pattern obtained was observed at a magnification of 20 times, using an FDP microscope MX61 (manufactured by Olympus Corporation). In the case of a positive film, the film thickness of the exposed portion was measured, and the minimum exposure dose was determined so that the exposed portion could have a film thickness of 5 nm or less (equal to or lower than the detection limit), and so that the mask size could allow a 100 µm line pattern to be opened. This minimum exposure dose was taken as the sensitivity. In the case of a negative film, the film thickness of the exposed portion was measured, and the minimum exposure dose was determined so that the remaining film ratio of the exposed portion could be more than 80%, and so that the mask size could allow a 100 µm line pattern to be opened. This minimum exposure dose was taken as the sensitivity.

The evaluation was made as described below. A, B, C, D, and E, which achieved a sensitivity of less than 1000 mJ/cm², were rated acceptable, and F, which achieved a sensitivity of 1000 mJ/cm² or more, was rated poor. Here, A is the best.
A: The minimum exposure dose for opening a 100 µm line pattern was less than 200 mJ/cm².
B: The minimum exposure dose for opening a 100 µm line pattern was 200 mJ/cm² or more and less than 400 mJ/cm².
C: The minimum exposure dose for opening a 100 µm line pattern was 400 mJ/cm² or more and less than 600 mJ/cm².
D: The minimum exposure dose for opening a 100 µm line pattern was 600 mJ/cm² or more and less than 800 mJ/cm².
E: The minimum exposure dose for opening a 100 µm line pattern was 800 mJ/cm² or more and less than 1000 mJ/cm².
F: The minimum exposure dose for opening a 100 µm line pattern was 1000 mJ/cm² or more.

### (5) Migration resistance

The varnish was applied to a migration evaluation substrate (WALTS-TEG ME0102JY, manufactured by WALTZ CO., Ltd.), using a spin coater (MS-A100, manufactured by Mikasa Co., Ltd.), and then prebaked at 100°C for 5 minutes, using a buzzer hot plate (HPD-3000BZN, manufactured by AS ONE Corporation). In the case of a positive photosensitive resin composition, a prebaked film having a thickness of 15.0 µm was produced. In the case of a negative photosensitive resin composition, an 18.0 µm prebaked film was prepared. The negative photosensitive resin composition was exposed to the i-line (the wavelength, 365 nm) of an ultrahigh pressure mercury lamp at 500 mJ/cm², using a double-sided alignment singlesided exposure device (Mask Aligner PEM-6M, manufactured by Union Optical Co., Ltd.). The negative photosensitive resin composition after the exposure was baked at 120°C for 1 minute, using the buzzer hot plate. The resulting film was heat-cured for 60 minutes at the temperature shown in Table 3, using a high-temperature inert gas oven (INH-9CD-S, manufactured by Koyo Thermo Systems Co., Ltd.) to produce a cured film having a thickness of approximately 10 µm.

Next, in the line and space pattern of the comb-like copper wiring, a lead wire was soldered to the measuring terminal having a line of 15 µm and a space of 10 µm to produce an evaluation element. The insulation reliability of the evaluation element produced was evaluated under high temperature and high humidity, using an insulation degradation characteristic evaluation system (ETAC SIR13, manufactured by Kusumoto Chemicals, Ltd.). The evaluation element was placed in a high-temperature, high-humidity chamber with the test conditions set at a temperature of 85°C and a humidity of 85% RH. A voltage of 5.0 V was applied. The change in resistance value over time was measured at 5-minute intervals, and the time (test time) taken until the resistance value reached 1.0 × 10⁶ Ω or less was determined. This test time is an indicator of migration resistance. The test times obtained were evaluated as described below. A+, A, B+, B, C+, and C, which were test times of 200 hours or more, were rated acceptable. A+, A, B+, and B, which were test times of 400 hours or more, were rated good. A+ and A, which were test times of 800 hours or more, were rated excellent.
A+: The test time was 1,000 hours or more.
A: The test time was 800 hours or more and less than 1,000 hours.
B+: The test time was 600 hours or more and less than 800 hours.
B: The test time was 400 hours or more and less than 600 hours.
C+: The test time was 300 hours or more and less than 400 hours.
C: The test time was 200 hours or more and less than 300 hours.
D: The test time was 50 hours or more and less than 200 hours.
E: The test time was less than 50 hours or unmeasurable.

### (6) Adhesion test

Adhesion to a metal material was tested, using the following method.

Copper was sputtered onto a silicon wafer to prepare a substrate (coppersputtered substrate) that had a metal material layer formed on the surface thereof, and had a thickness of 200 nm. In the same manner as in (5), the varnish was applied to this substrate, exposed to light, and heat-treated to obtain a cured film having a thickness of approximately 10 µm.

The film after the heat treatment was incised with a grid pattern of 10 rows and 10 columns at 2 mm intervals, using a single-edged blade. Next, using a pressure cooker test (PCT) device (HAST CHAMBER EHS-211MD, manufactured by Tabai Espec Corp.), the resulting film was subjected to PCT treatment for 400 hours under saturated conditions at 121°C and 2 atm. Then, using Cello-tape (registered trademark), peeling was tried on the film. How many squares out of 100 squares were successfully peeled off was counted. The properties of adhesion between the metal material and the cured resin film were thus evaluated. The results were rated as described below. A, B and C, which indicated that the number of squares peeled off in the peeling test was less than 40, were rated good, and D was rated poor.
A: The number of squares peeled off was 0.
B: The number of squares peeled off was 1 or more and 10 or less.
C: The number of squares peeled off was 11 or more and 20 or less.
D: The number of squares peeled off was 21 or more.

### (7) Heat resistance (measurement of 5% weight loss temperature)

In the same manner as in (5), the varnish was applied to a silicon wafer, exposed to light, and heat-treated to obtain a cured film having a thickness of approximately 10 µm. The resulting cured film was peeled off from the silicon wafer to produce a single film (cured film). The 5% weight loss temperature of the cured film produced was measured, using a differential thermal and thermogravimetric simultaneous measuring device (DTG-60A, Shimadzu Corporation). The measurement was performed under the following conditions: the test temperature, room temperature (25°C) to 550°C; the temperature-raising rate, 10°C/min; the measurement atmosphere, nitrogen; and the sample weight, 15 mg. The heat resistance in Examples and Comparative Examples was evaluated as described below, using, as an indicator of heat resistance, the 5% weight loss temperature [°C] of the single film (cured film) measured in this manner. Here, A is the best.
A: The 5% weight loss temperature was 500°C or higher.
B: The 5% weight loss temperature was 450°C or higher and lower than 500°C.
C: The 5% weight loss temperature was 400°C or higher and lower than 450°C.
D: The 5% weight loss temperature was 350°C or higher and lower than 400°C.
E: The 5% weight loss temperature was lower than 350°C.

### (8) Amount of halogen elements in photosensitive resin composition (amount of halogen)

Measurements were made, using a method based on IEC 62321-3-2. In a pretreatment, a sample was combusted, using a technique based on BS EN 14582, the combustion gas was absorbed into an absorbing liquid, and the absorbing liquid was measured, using an ion chromatograph. Here, ppm is a unit of concentration based on weight, and is calculated as the weight (mg) of halogen per kg of sample.

### <Combustion and absorption conditions>

System: AQF-2100H, GA-210 (Mitsubishi Chemical Corporation)
Electric furnace temperature: Inlet, 900°C; Outlet, 1000°C
Gas: Ar/O₂, 200 mL/min; O₂, 400 mL/min
Absorbing liquid: H₂O₂, 0.1 mass%
Amount of absorbing liquid: 5 mL

### <Ion chromatography and anion analysis conditions>

System: ICS1600 (manufactured by DIONEX Corporation)
Mobile phase: 2.7 mmol/L, Na₂CO₃; 0.3 mmol/L, NaHCO₃
Flow rate: 1.50 mL/min
Detector: electrical conductivity detector
Volume of injection: 100 µL

The abbreviations of the compounds used in Synthesis Examples and Examples are listed below.
BAHF: 2,2-bis(3-amino-4-hydroxyphenyl)hexafluoropropane (manufactured by Central Glass Co., Ltd.)
SiDA: 1,3-bis(3-aminopropyl)tetramethyldisiloxane
MAP: 3-aminophenol (manufactured by Tokyo Chemical Industry Co., Ltd.)
NMP: N-methyl-2-pyrrolidone
ODPA: 4,4'-oxydiphthalic anhydride
DFA: dimethylformamide dimethyl acetal (manufactured by Mitsubishi Rayon Co., Ltd.)
TDA-100: 4-(2,5-dioxotetrahydrofuran-3-yl)-1,2,3,4-tetrahydronaphthalene-1,2-dicarboxylic dianhydride
GBL: γ-butyrolactone
OBBOC: 4,4'-oxybenzoyl chloride
PBOM: a compound having the structure shown below (1,1'-(4,4'-oxybis)benzoyldiimidazole)

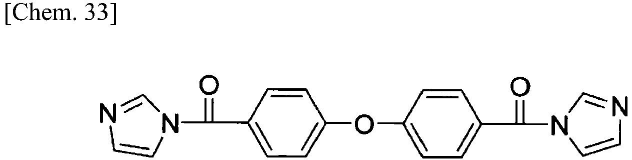

BAP: 2,2-bis(3-amino-4-hydroxyphenyl)propane
DAE: 4,4'-diaminodiphenylether
NA: 5-norbornene-2,3-dicarboxylic anhydride
XLN: 2,6-xylenol
SAD: salicylaldehyde
BAD: benzaldehyde
HAD: formaldehyde
HST: 4-hydroxystyrene
STR: styrene
MeTMS: methyltrimethoxysilane
PhTMS: phenylmethoxysilane
cyEpoTMS: 2-(3,4-epoxycyclohexyl)ethyltrimethoxysilane
TMOS: tetramethoxysilane
HEMA: 2-hydroxyethyl methacrylate
MPA: 3-methoxy-N,N-dimethylpropanamide (manufactured by KJ Chemicals Corporation)
DCC: dicyclohexylcarbodiimide
DMIB: N,N-dimethylisobutylamide
TrisP-HAP: tradename, manufactured by Honshu Chemical Industry Co., Ltd.
NAC-5: 5-naphthoquinone diazide sulfonyl chloride (manufactured by Toyo Gosei Co., Ltd.).

### <Synthesis Example 1: Synthesis of diamine compound containing hydroxyl group (HA)>

BAHF in an amount of 18.3 g (0.05 mol) was dissolved in 100 mL of acetone and 17.4 g (0.3 mol) of propylene oxide (manufactured by Tokyo Chemical Industry Co., Ltd.), and the resulting solution was cooled to -15°C. To the resulting solution, a solution of 20.4 g (0.11 mol) of 3-nitrobenzoyl chloride ((manufactured by Tokyo Chemical Industry Co., Ltd.) dissolved in 100 mL of acetone was added dropwise. Upon completion of the dropwise addition, the resulting mixture was stirred at -15°C for 4 hours, and then allowed to return to room temperature. A white solid was precipitated, separated by filtration, and dried in vacuo at 50°C.

The resulting white solid in an amount of 30 g was placed in a 300 mL stainless steel autoclave, and dispersed in 250 mL of methyl cellosolve, and 2 g of 5% palladium on carbon (manufactured by Wako Pure Chemical Industries, Ltd.) was added. Into the resulting mixture, hydrogen was introduced, using a balloon, and the resulting mixture was subjected to reduction reaction at room temperature. After about 2 hours, the reaction was terminated when no more deflation of the balloon was confirmed. Upon completion of the reaction, the palladium compound as a catalyst was removed by filtration, and the resulting mixture was concentrated, using a rotary evaporator to obtain a diamine compound containing hydroxyl group (HA) of the following Formula.

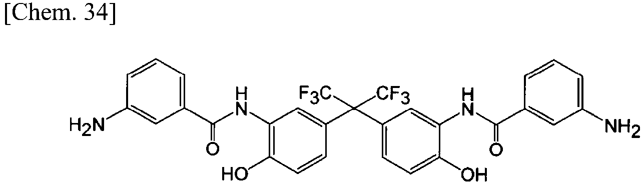

### <Synthesis Example 2: Synthesis of polyimide (a-1)>

Under a dry nitrogen gas stream, 29.3 g (0.08 mol) of BAHF, 1.2 g (0.005 mol) of SiDA, and 3.3 g (0.03 mol) of MAP as an end-capping agent were dissolved in 80 g of NMP. To the resulting solution, 31.2 g (0.1 mol) of ODPA together with 20 g of NMP was added, and the resulting mixture was allowed to react at 60°C for 1 hour, and then stirred at 180°C for 4 hours. Upon completion of the stirring, the solution was poured into 3 L of water to obtain a white precipitate. The precipitate was collected by filtration, washed with water three times, and then dried in a vacuum dryer at 80°C for 20 hours to obtain a powder of the polyimide (a-1).

### <Synthesis Example 3: Synthesis of polyimide precursor (a-2)>

Under a dry nitrogen gas stream, 51.4 g (0.085 mol) of the diamine containing a hydroxyl group (HA) obtained in Synthesis Example 1 and 1.2 g (0.005 mol) of SiDA were dissolved in 200 g of NMP. To the resulting solution, 31.0 g (0.100 mol) of ODPA was added, and the resulting mixture was stirred at 40°C for 2 hours. Then, 2.2 g (0.02 mol) of MAP as an end-capping agent was added together with 10 g of NMP, and the resulting mixture was allowed to react at 40°C for 1 hour. Then, a solution prepared by diluting 21.5 g (0.18 mol) of DFA with 10 g of NMP was added dropwise. After the dropwise addition, stirring was continued at 40°C for 2 hours. Upon completion of the stirring, the resulting solution was poured into 2 L of water, and a polymer solid precipitated was collected by filtration. The resulting mixture was further washed with 2 L of water three times, and the polymer solid collected was dried in a vacuum dryer at 50°C for 72 hours to obtain a polyimide precursor (a-2).

### <Synthesis Example 4: Synthesis of polyimide (a-3)>

Under a dry nitrogen gas stream, 30.03 g (0.100 mol) of TDA-100 and 100 g of GBL were added to a three-necked flask, and dissolved with stirring at 60°C. Subsequently, 1.09 g (0.010 mol) of MAP and 32.96 g (0.090 mol) of BAHF were added, and the resulting mixture was stirred at 60°C for 1 hour, then heated to 200°C, and stirred for 4 hours. Upon completion of the stirring, the solution was poured into 3 L of water to obtain a white precipitate. The precipitate was collected by filtration, washed with water three times, and then dried in a vacuum dryer at 80°C for 20 hours to obtain a powder of the polyimide (a-3).

### <Synthesis Example 5: Synthesis of polybenzoxazole precursor (a-4)>

Under a dry nitrogen gas stream, 34.8 g (0.1 mol) of BAHF and 1.2 g (0.01 mol) of SiDA were dissolved in 200 g of NMP. Subsequently, with the temperature maintained at 0 to 5°C, 23.6 g (0.08 mol) of 4,4'-oxybenzoyl chloride was added together with 50 g of NMP, and the resulting mixture was allowed to react for 1 hour. Next, the temperature was returned to room temperature, and 6.6 g (0.04 mol) of 5-norbornene-2,3-dicarboxylic anhydride was added together with 10 g of NMP. The resulting mixture was allowed to react for another 1 hour. Upon completion of the reaction, the resulting solution was poured into 3.0 L of water to obtain a white precipitate. The precipitate was collected by filtration, washed with water three times, and then dried in a forced air dryer at 50°C for 3 days to obtain a powder of the polybenzoxazole precursor (a-4).

### <Synthesis Example 6: Synthesis of phenolic resin (a-5)>

The phenolic resin (a-5) of Synthesis Example 6 was synthesized, using the method described in Synthesis Example 5 in paragraph [0120] in WO2012/141165.

### <Synthesis Example 7: Synthesis of polyhydroxystyrene (a-6)>

The polyhydroxystyrene (a-6) of Synthesis Example 7 was synthesized, using the method described in Synthesis Example 23 in paragraph [0742] in WO2017/159876.

### <Synthesis Example 8: Synthesis of polysiloxane (a-7)>

The polysiloxane (a-7) was synthesized, using the method described in Synthesis Example 30 in paragraph [0553] in WO2017/057281.

### <Synthesis Example 9: Synthesis of polyimide precursor (a-8)>

In a 2-liter separatory flask, 24.8 g (0.08 mol) of ODPA was placed, and 21.9 g (0.17 mol) of HEMA and 310 g of MPA were added. With stirring at room temperature, 12.7 g (0.16 mol) of pyridine was added to obtain a reaction mixture (ODPA-HEMA). Upon termination of the heat generation due to the reaction, the resulting mixture was allowed to cool to room temperature, and then allowed to stand for another 16 hours.

Next, to the reaction mixture, a solution of 28.9 g (0.14 mol) of dicyclohexylcarbodiimide (DCC) dissolved in 180 g of MPA was added with stirring under ice cooling over a period of 40 minutes. Subsequently, a suspension of 114.9 g (0.19 mol) of HA and 2.5 g (0.01 mol) of SiDA suspended in 230 g of MPA was added with stirring over a period of 60 minutes. After further stirring at room temperature for 2 hours, 31.0 g (0.16 mol) of ODPA was added, and stirring was continued at room temperature for 3 hours. Then, 4.3 g (0.04 mol) of MAP was added, and stirring was continued at room temperature for 1 hour. Then, a precipitate formed in the reaction mixture was removed by filtration to obtain a reaction liquid.

The reaction liquid was poured into 3 L of water to obtain a white precipitate. The precipitate was collected by filtration, washed with water twice, washed with isopropanol once, and then dried in a vacuum dryer at 50°C for 72 hours to obtain a polyimide precursor (a-8).

### <Synthesis Example 10: Synthesis of polyimide precursor (a-9)>

A polyimide precursor (a-9) was obtained in the same manner as in Synthesis Example 3 except that NMP was changed to MPA.

### <Synthesis Example 11: Synthesis of polyimide precursor (a-10)>

A polyimide precursor (a-10) was obtained in the same manner as in Synthesis Example 3 except that NMP was changed to DMIB.

### <Synthesis Example 12: Synthesis of polyimide precursor (a-11)>

A polyimide precursor (a-11) was obtained in the same manner as in Synthesis Example 3 except that the amount of DFA was changed from 21.5 g (0.18 mol) to 17.9 g (0.15 mol).

### <Synthesis Example 13: Synthesis of polyimide precursor (a-12)>

A polyimide precursor (a-12) was obtained in the same manner as in Synthesis Example 3 except that the amount of DFA was changed from 21.5 g (0.18 mol) to 23.8 g (0.20 mol).

### <Synthesis Example 14: Synthesis of quinone diazide compound (b-1)>

Under a dry nitrogen gas stream, 15.31 g (0.05 mol) of TrisP-HAP and 26.86 g (0.10 mol) of NAC-5 were dissolved in 450 g of 1,4-dioxane, and the resulting solution was brought to room temperature. To the solution, a mixture of 50 g of 1,4-dioxane and 15.18 g of triethylamine was added dropwise in such a manner that the inside of the reaction system did not reach 35°C or more. After the dropwise addition, the resulting mixture was stirred at 30°C for 2 hours. The triethylamine salt was removed by filtration, and the filtrate was poured into 3 L of water to obtain a precipitate. The precipitate was collected by filtration and washed with 1 L of 1 wt% hydrochloric acid. Then, the precipitate was further washed with 2 L of water twice. This precipitate was dried in a vacuum dryer to obtain a quinone diazide compound (b-1) represented by Formula (4), in which compound an average of two of the Qs in one molecule were formed into a 5-naphthoquinone diazide sulfonic acid ester.

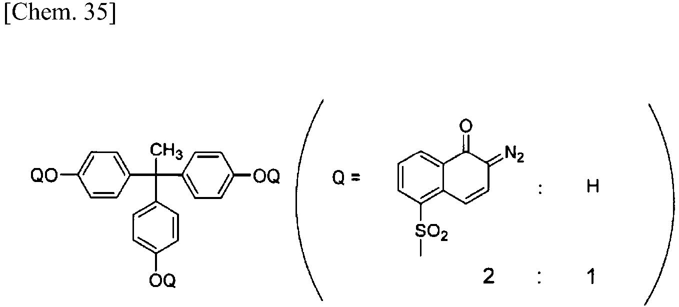

### <Synthesis Example 15: Synthesis of polyimide precursor (a-13)>

Under a dry nitrogen gas stream, 22.0 g (0.085 mol) of BAP and 1.2 g (0.005 mol) of SiDA were dissolved in 200 g of NMP. To the resulting solution, 31.0 g (0.100 mol) of ODPA was added, and the resulting mixture was stirred at 40°C for 2 hours. Then, 2.2 g (0.02 mol) of MAP as an end-capping agent was added together with 10 g of NMP, and the resulting mixture was allowed to react at 40°C for 1 hour. Then, a solution prepared by diluting 23.8 g (0.2 mol) of DFA with 10 g of NMP was added dropwise. After the dropwise addition, stirring was continued at 40°C for 2 hours. Upon completion of the stirring, the resulting solution was poured into 2 L of water, and a polymer solid precipitated was collected by filtration. The resulting mixture was further washed with 2 L of water three times, and the polymer solid collected was dried in a vacuum dryer at 50°C for 72 hours to obtain a polyimide precursor (a-13).

### <Synthesis Example 16: Synthesis of polybenzoxazole precursor (a-14)>

Under a dry nitrogen gas stream, 24.5 g (0.095 mol) of BAP and 1.2 g (0.005 mol) of SiDA were dissolved in 200 g of NMP. PBOM in an amount of 28.7 g (0.08 mol) was added together with 50 g of NMP. The resulting mixture was allowed to react at 85°C for 1 hour. Next, 6.6 g (0.04 mol) of 5-norbornene-2,3-dicarboxylic anhydride was added together with 10 g of NMP. The resulting mixture was allowed to react for another 1 hour. Upon completion of the reaction, the resulting solution was poured into 3.0 L of water to obtain a white precipitate. The precipitate was collected by filtration, washed with water three times, and then dried in a forced air dryer at 50°C for 3 days to obtain a powder of the polybenzoxazole precursor (a-14).

### <Synthesis Example 17: Synthesis of polyimide precursor (a-15)>

A polyimide precursor (a-15) was obtained in the same manner as in Synthesis Example 9 except that HA was changed to an equimolar amount of DAE.

Table 1-1 and Table 1-2 show the measurement results of Synthesis Examples 2 to 13, 15, and 16, as follows: the constituent components (molar ratio); the molecular weight (Mw); the esterification rate [%], and the amounts [part(s) by mass] of the compounds represented by Formula (5) and Formula (6).

**[Table 1-1]**

| | Resin (A) | Tetracarboxylic acid and derivative thereof (molar ratio) | | Diamine and derivative thereof (molar ratio) | | End-capping agent (molar ratio) | Solvent | Evaluation of resin | | |
|---|---|---|---|---|---|---|---|---|---|---|
| | | | | | | | | Weight average molecular weight | Esterification rate [%] | Contents of compound represented by Formula (5) and compound represented by Formula (6) [part(s) by mass] |
| Synthesis Example 2 | polyimide (a-1) | ODPA (100) | - | BAHF (85) | SiDA (5) | MAP (20) | NMP | 25000 | - | - |
| Synthesis Example 3 | polyimide precursor (a-2) | ODPA (100) | - | HA (85) | SiDA (5) | MAP (20) | NMP | 33000 | 50 | - |
| Synthesis Example 4 | polyimide (a-3) | TDA-100 (100) | - | BAHF (90) | - | MAP (10) | GBL | 25000 | - | - |
| Synthesis Example 5 | polybenzoxazole precursor (a-4) | OBBOC (80) | - | BAHF (95) | SiDA (5) | NA (40) | NMP | 25000 | - | - |
| Synthesis Example 9 | polyimide precursor (a-8) | ODPA-HEMA (50) | ODPA (50) | HA (85) | SiDA (5) | MAP (20) | MPA | 25000 | 40 | 4.5 |
| Synthesis Example 10 | polyimide precursor (a-9) | ODPA (100) | - | HA (85) | SiDA (5) | MAP (20) | MPA | 34000 | 48 | 4.2 |
| Synthesis Example 11 | polyimide precursor (a-10) | ODPA (100) | - | HA (85) | SiDA (5) | MAP (20) | DMIB | 34000 | 45 | 5.0 |
| Synthesis Example 12 | polyimide precursor (a-11) | ODPA (100) | - | HA (85) | SiDA (5) | MAP (20) | NMP | 30000 | 40 | - |
| Synthesis Example 13 | polyimide precursor (a-12) | ODPA (100) | - | HA (85) | SiDA (5) | MAP (20) | NMP | 33000 | 76 | - |
| Synthesis Example 15 | polyimide precursor (a-13) | ODPA (100) | - | BAP (85) | SiDA (5) | MAP (20) | NMP | 33000 | 60 | - |
| Synthesis Example 16 | polybenzoxazole precursor (a-14) | PBOM (80) | - | BAP (95) | SiDA (5) | NA (40) | NMP | 25000 | - | - |
| Synthesis Example 17 | polyimide precursor (a-15) | ODPA-HEMA (50) | ODPA (50) | DAE (85) | SiDA (5) | MAP (20) | MPA | 25000 | 40 | 4.5 |

**[Table 1-2]**

| | Polymer | Monomer [mol%] | | | | | Weight average molecular weight | Acid equivalent (= phenol equivalent) [g/mol] | Double bond equivalent [g/mol] | Contents of compound represented by Formula (5) and compound represented by Formula (6) [parts by mass] |
|---|---|---|---|---|---|---|---|---|---|---|
| | | Phenolic compound | | Aldehyde compound Bisalkoxymethyl compound | | | | | | |
| Synthesis Example 6 | phenolic resin (a-5) | XLN (200) | - | SAD (100) | BAD (25) | HAD (75) | 4,000 | 130 | - | - |

| | Polymer | Monomer [molar ratio] | | | | | Weight average molecular weight | Acid equivalent (= phenol equivalent) [g/mol] | Double bond equivalent [g/mol] | Contents of compound represented by Formula (5) and compound represented by Formula (6) [parts by mass] |
|---|---|---|---|---|---|---|---|---|---|---|
| | | Hydroxystyrene copolymer component | | Styrene copolymer component | | | | | | |
| Synthesis Example 7 | polyhydroxystyrene (a-6) | HST (80) | | STR (20) | | | 9,500 | 150 | - | - |

| | Polymer | Monomer [mol%] | | | | Weight average molecular weight | Acid equivalent (= silanol equivalent) [g/mol] | Double bond equivalent [g/mol] | Contents of compound represented by Formula (5) and compound represented by Formula (6) [parts by mass] | |
|---|---|---|---|---|---|---|---|---|---|---|
| | | Trifunctional organosilane | | | Tetrafunctional organosilane | | | | | |
| Synthesis Example 8 | polysiloxane (a-7) | MeTMS (30) | PhTMS (50) | cyEpoTMS (10) | TMOS (10) | 4,500 | 360 | - | - | |

### <Examples and Comparative Examples>

The components were mixed as shown in Table 2 to obtain each resin composition. In this regard, the resin composition of Example 14 further contained 4.3 parts by mass of MPA together with the resin (a-8) of Synthesis Example 9, with respect to 100 parts by mass of the resin (a-8). The resin composition of Example 15 further contained 4.0 parts by mass of MPA together with the resin (a-9) of Synthesis Example 10, with respect to 100 parts by mass of the resin (a-9). The resin composition of Example 16 further contained 4.3 parts by mass of DMIB together with the resin (a-10) of Synthesis Example 11, with respect to 100 parts by mass of the resin (a-10). In Table 2, the numbers in parentheses indicate the solid content [part(s) by mass] of each component. Using γ-butyrolactone as a solvent, the composition was prepared so as to have the solid content concentration at 45 mass%.

**[Table 2]**

| | Component (A) (blending amount) | Component (B) (blending amount) | Component (C) (blending amount) | Component (D) (blending amount) | Component (E), Component (F) (blending amount) | Another additive | Solvent |
|---|---|---|---|---|---|---|---|
| Example 1 | (a-1) (100 parts by mass) | (b-1) (20 parts by mass) | (c-1) (20 parts by mass) | (d-1) (2.8 parts by mass) | - | - | GBL |
| Example 2 | (a-2) (100 parts by mass) | (b-2) (3 parts by mass) | (c-3) (2.0 parts by mass) | (d-2) (1.6 parts by mass) | (f-1) (48 parts by mass) | - | GBL |
| Example 3 | (a-3) (100 parts by mass) | (b-2) (3 parts by mass) | (c-3) (2.0 parts by mass) | (d-2) (1.6 parts by mass) | (f-2) (48 parts by mass) | - | GBL |
| Example 4 | (a-4) (100 parts by mass) | (b-2) (3 parts by mass) | (c-3) (2.0 parts by mass) | (d-2) (1.6 parts by mass) | (f-1) (48 parts by mass) | - | GBL |
| Example 5 | (a-2) (60 parts by mass) | (b-1) (20 parts by mass) | (c-2) (5 parts by mass) | (d-1) (2.8 parts by mass) | (f-3) (15 parts by mass) | - | GBL |
| | (a-5) (40 parts by mass) | | | | | | |
| Example 6 | (a-2) (60 parts by mass) | (b-1) (20 parts by mass) | (c-2) (5 parts by mass) | (d-1) (2.8 parts by mass) | (f-3) (15 parts by mass) | - | GBL |
| | (a-6) (40 parts by mass) | | | | | | |
| Example 7 | (a-2) (60 parts by mass) | (b-1) (20 parts by mass) | (c-2) (5 parts by mass) | (d-1) (2.8 parts by mass) | (f-3) (15 parts by mass) | - | GBL |
| | (a-7) (40 parts by mass) | | | | | | |
| Example 8 | (a-2) (100 parts by mass) | (b-1) (20 parts by mass) | (c-2) (5 parts by mass) | (d-1) (2.8 parts by mass) | (f-1) (15 parts bv mass) | - | GBL |
| Example 9 | (a-1) (100 parts by mass) | (b-1) (20 parts by mass) | (c-1) (5 parts by mass) | (d-1) (2.8 parts by mass) | - | - | GBL |
| Example 10 | (a-1) (100 parts by mass) | (b-1) (20 parts by mass) | (c-1) (5 parts by mass) | (d-2) (2.8 parts by mass) | - | - | GBL |
| Example 11 | (a-2) (100 parts by mass) | (b-1) (20 parts by mass) | (c-1) (5 parts by mass) | (d-2) (2.8 parts by mass) | - | - | GBL |
| Example 12 | (a-4) (100 parts by mass) | (b-1) (20 parts by mass) | (c-1) (5 parts by mass) | (d-2) (2.8 parts by mass) | - | - | GBL |
| Example 13 | (a-2) | (b-3) | (c-3) | (d-2) | (e-1) | - | GBL |
| | (100 parts by mass) | (4.8 parts by mass) | (2.1 parts by mass) | (1.4 parts by mass) | (42 parts by mass) | | |
| Example 14 | (a-8) (100 parts by mass) | (b-3) (5 parts by mass) | (c-3) (2.1 parts by mass) | (d-2) (1.4 parts by mass) | (e-1) (42 parts by mass) | - | GBL |
| Example 15 | (a-9) (100 parts by mass) | (b-3) (4.8 parts by mass) | (c-3) (2.1 parts by mass) | (d-2) (1.4 parts by mass) | (e-1) (42 parts by mass) | - | GBL |
| Example 16 | (a-10) (100 parts by mass) | (b-3) (4.8 parts by mass) | (c-3) (2.1 parts by mass) | (d-2) (1.4 parts by mass) | (e-1) (42 parts by mass) | - | GBL |
| Example 17 | (a-2) (100 parts by mass) | (b-3) (4.8 parts by mass) | (c-3) (16.8 parts by mass) | (d-2) (1.4 parts by mass) | (e-1) (42 parts by mass) | - | GBL |
| Example 18 | (a-2) (100 parts by mass) | (b-3) (4.8 parts by mass) | (c-3) (0.42 part by mass) | (d-2) (1.4 parts by mass) | (e-1) (42 parts by mass) | - | GBL |
| Example 19 | (a-2) (100 parts by mass) | (b-3) (4.8 parts by mass) | (c-3) (1.0 part by mass) | (d-2) (1.0 part by mass) | (e-1) (42 parts by mass) | - | GBL |
| Example 20 | (a-2) (100 parts by mass) | (b-3) (4.8 parts by mass) | (c-3) (4.7 parts by mass) | (d-2) (1.0 part by mass) | (e-1) (42 parts by mass) | - | GBL |
| Example 21 | (a-2) (100 parts by mass) | (b-3) (4.8 parts by mass) | (c-3) (3.4 parts by mass) | (d-2) (0.7 parts by mass) | (e-1) (42 parts by mass) | - | GBL |
| Example 22 | (a-2) (100 parts by mass) | (b-3) (4.8 parts by mass) | (c-3) (1.4 parts by mass) | (d-2) (2.9 parts by mass) | (e-1) (42 parts by mass) | - | GBL |
| Example 23 | (a-12) (100 parts by mass) | (b-3) (4.8 parts by mass) | (c-3) (2.1 parts by mass) | (d-2) (1.4 parts by mass) | (e-1) (42 parts by mass) | - | GBL |
| Example 24 | (a-11) (100 parts by mass) | (b-3) (4.8 parts by mass) | (c-3) (2.1 parts by mass) | (d-2) (1.4 parts by mass) | (e-1) (42 parts by mass) | - | GBL |
| Example 25 | (a-7) (100 parts by mass) | (b-1) (20 parts by mass) | (c-1) (5 parts by mass) | (d-1) (2.8 parts by mass) | (f-3) (15 parts by mass) | - | GBL |
| Example 26 | (a-2) (100 parts by mass) | (b-3) (4.8 parts by mass) | (c-3) (2.1 parts by mass) | (d-2) (1.4 parts by mass) | (e-1) (42 parts by mass) (e-2) (14 parts by mass) | - | GBL |
| Example 27 | (a-4) (100 parts by mass) | (b-3) (4.8 parts by mass) | (c-3) (2.1 parts by mass) | (d-2) (1.4 parts by mass) | (e-1) (42 parts by mass) | - | GBL |
| Example 28 | (a-13) (100 parts by mass) | (b-3) (4.8 parts by mass) | (c-3) (2.1 parts by mass) | (d-2) (1.4 parts by mass) | (e-1) (42 parts by mass) | - | GBL |
| Example 29 | (a-14) (100 parts by mass) | (b-3) (4.8 parts by mass) | (c-3) (2.1 parts by mass) | (d-2) (1.4 parts by mass) | (e-1) (42 parts by mass) | - | GBL |
| Example 30 | (a-2) (100 parts by mass) | (b-3) (4.8 parts by mass) | (c-3) (18.0 parts by mass) | (d-2) (1.4 parts by mass) | (e-1) (42 parts by mass) | - | GBL |
| Example 31 | (a-2) | (b-3) | (c-3) | (d-2) | (e-1) | - | GBL |
| | (100 parts by mass) | (4.8 parts by mass) | (0.3 part by mass) | (1.4 part by mass) | (42 parts by mass) | | |
| Example 32 | (a-2) (100 parts by mass) | (b-3) (4.5 parts by mass) | (c-3) (1.0 part by mass) | (d-2) (1.0 part by mass) | (e-1) (42 parts by mass) | - | GBL |
| Example 33 | (a-2) (100 parts by mass) | (b-3) (4.8 parts by mass) | (c-3) (5.4 parts by mass) | (d-2) (1.2 parts by mass) | (e-1) (42 parts by mass) | - | GBL |
| Example 34 | (a-2) (100 parts by mass) | (b-3) (4.8 parts by mass) | (c-3) (2.6 parts by mass) | (d-2) (0.5 part by mass) | (e-1) (42 parts by mass) | - | GBL |
| Example 35 | (a-2) (100 parts by mass) | (b-3) (4.8 parts by mass) | (c-3) (1.0 part by mass) | (d-2) (3.0 parts by mass) | (e-1) (42 parts by mass) | - | GBL |
| Example 36 | (a-15) (100 parts by mass) | (b-3) (5 parts by mass) | (c-3) (2.1 parts by mass) | (d-2) (1.4 parts by mass) | (e-1) (42 parts by mass) | - | GBL |
| Comparative Example 1 | (a-5) (100 parts by mass) | (b-1) (20 parts by mass) | - | - | (f-1) (15 parts by mass) | KBM-403 (1.0 part by mass) | GBL |
| Comparative Example 2 | (a-6) (100 parts by mass) | (b-3) (20 parts by mass) | (c-1) (5 parts by mass) | - | (e-1) (42 parts by mass) | KBM-403 (1.0 part by mass) | GBL |

The components listed in Table 2 are as follows:
Component (A)
   (a-1) and (a-3): the above-described polyimide resin (a-1) and polyimide resin (a-3) respectively
   (a-2), (a-8) to (a-13), and (a-15): the above-described polyimide precursor resin (a-2), polyimide precursor resin (a-8) to polyimide precursor resin (a-13), and polyimide precursor resin (a-15) respectively
   (a-4) and (a-14): the above-described polybenzoxazole precursor resin (a-4) and polybenzoxazole precursor resin (a-14) respectively
   (a-5): the above-described phenolic resin (a-5)
   (a-6): the above-described polyhydroxystyrene resin (a-6)
   (a-7): the above-described polysiloxane resin (a-7)
Component (B)
   (b-1): the above-described quinone diazide compound (b-1)
   (b-2): CPI-310FG: a sulfonium salt containing a gallate ion (tradename, manufactured by Sun Apro Co., Ltd.)
   (b-3): NCI-930 (manufactured by ADEKA Corporation)
Component (C)
   (c-1): MX-750LM (manufactured by Sanwa Chemical Co., Ltd.)
   (c-2): 1,3,5-triazine (manufactured by Tokyo Chemical Industry Co., Ltd.)
   (c-3): MW-390 (manufactured by Sanwa Chemical Co., Ltd.) 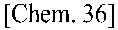 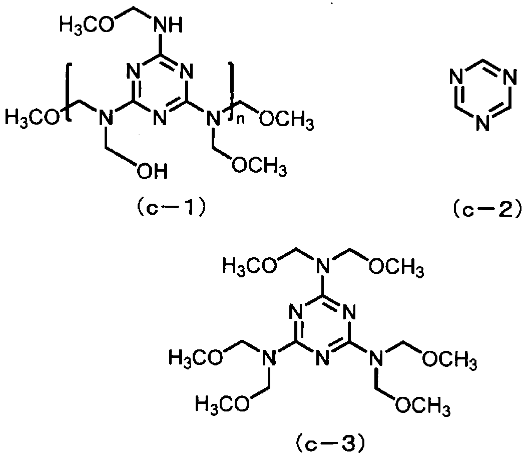
Component (D)
   (d-1): X-12-1116 (manufactured by Shin-Etsu Chemical Co., Ltd.)
   (d-2): X-12-989MS (manufactured by Shin-Etsu Chemical Co., Ltd.) 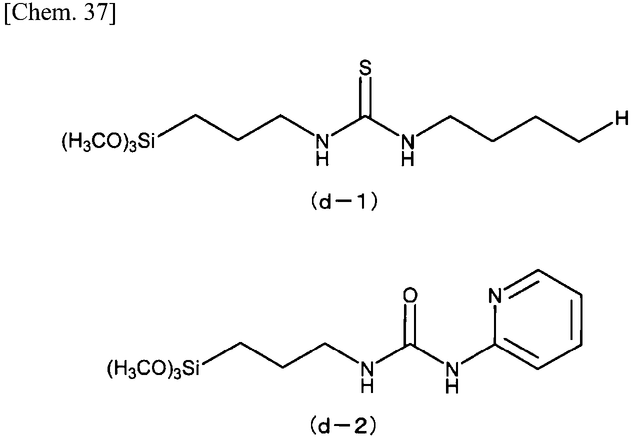
Component (E)
   (e-1) NK Ester 4G (manufactured by Shin Nakamura Chemical Co., Ltd.)
   (e-2) NK Ester 1G (manufactured by Shin Nakamura Chemical Co., Ltd.)
Component (F)
   (f-1) HMOM-HAP (tradename; a methoxymethyl crosslinking agent; manufactured by Honshu Chemical Industry Co., Ltd.)
   (f-2) YL980 (tradename; an epoxy crosslinking agent; manufactured by Mitsubishi Chemical Corporation)
   (f-3) PG-100 (tradename; an epoxy crosslinking agent; manufactured by Osaka Gas Chemicals Co., Ltd.)
   Another additive: KBM-403 (manufactured by Shin-Etsu Chemical Co., Ltd.)
   Solvent: GBL (y-butyrolactone, manufactured by Tokyo Chemical Industry Co., Ltd.)

The properties of the varnish obtained were measured, using the above-described evaluation methods. Table 3 shows: the temperature for the heat curing performed in the evaluation of (5) Migration resistance (the temperature is referred to as "Heat treatment temperature" in Table); the evaluation results of sensitivity and migration resistance; the evaluation results of adhesion tests; and the evaluation results of heat resistance.

**[Table 3]**

| | Photosensitivity | Compound represented by Formula (5), Compound represented by Formula (6) (Content)*¹ | α > β ≧ γ | α/β | β/γ | Content of halogen [ppm] | Heat treatment temperature | Sensitivity | Migration resistance | Adhesion test | Heat resistance |
|---|---|---|---|---|---|---|---|---|---|---|---|
| | | | | | | | (°C) | Evaluation results | Evaluation results | Evaluation results | Evaluation results |
| Example 1 | positive | - | × | 1.0 | 7.1 | 23000 (F) | 200 | E | C | C | C |
| Example 2 | negative | - | ○ | 1.5 | 1.3 | 25000 (F) | 350 | B | C | C | C |
| Example 3 | negative | - | ○ | 1.5 | 1.3 | 25000 (F) | 200 | B | C | C | D |
| Example 4 | negative | - | ○ | 1.5 | 1.3 | 50000 (F,Cl) | 200 | B | C | C | C |
| Example 5 | positive | - | ○ | 4.0 | 1.8 | 13000 (F) | 200 | D | C | C | D |
| Example 6 | positive | - | ○ | 4.0 | 1.8 | 13000 (F) | 200 | D | C | C | D |
| Example 7 | positive | - | ○ | 4.0 | 1.8 | 13000 (F) | 200 | D | C | C | C |
| Example 8 | positive | - | ○ | 4.0 | 1.8 | 22000 (F) | 200 | D | C | C | C |
| Example 9 | positive | - | ○ | 4.0 | 1.8 | 23000 (F) | 200 | E | C | C | B |
| Example 10 | positive | - | ○ | 4.0 | 1.8 | 23000 (F) | 200 | E | C | B | B |
| Example 11 | positive | - | ○ | 4.0 | 1.8 | 22000 (F) | 350 | D | B | B | B |
| Example 12 | positive | - | ○ | 4.0 | 1.8 | 23000 (F) | 350 | D | B | C | C |
| Example 13 | negative | - | ○ | 2.3 | 1.5 | 22000 (F) | 350 | B | B | B | B |
| Example 14 | negative | MPA (4.3 parts by mass) | ○ | 2.4 | 1.5 | 22000 (F) | 350 | A | A | A | A |
| Example 15 | negative | MPA (4.0 parts by mass) | ○ | 2.3 | 1.5 | 22000 (F) | 350 | B | A+ | A | A |
| Example 16 | negative | DMIB (4.8 parts by mass) | ○ | 2.3 | 1.5 | 22000 (F) | 350 | B | A+ | A | A |
| Example 17 | negative | - | × | 0.3 | 12.0 | 22000 (F) | 350 | B | A | C | A |
| Example 18 | negative | - | × | 11.4 | 0.3 | 22000 (F) | 350 | B | B | B | C |
| Example 19 | negative | - | ○ | 4.8 | 1.0 | 22000 (F) | 350 | B | B | A | B |
| Example 20 | negative | - | ○ | 1.0 | 4.7 | 22000 (F) | 350 | B | A | A | A |
| Example 21 | negative | - | × | 1.4 | 4.8 | 22000 (F) | 350 | B | B | C | B |
| Example 22 | negative | - | × | 3.4 | 0.5 | 22000 (F) | 350 | B | B | B | C |
| Example 23 | negative | - | ○ | 2.3 | 1.5 | 22000 (F) | 350 | B | A+ | A | A |
| Example 24 | negative | - | ○ | 2.3 | 1.5 | 22000 (F) | 350 | A | C+ | B | B |
| Example 25 | positive | - | ○ | 4.0 | 1.8 | < 50 | 200 | D | C | C | D |
| Example 26 | negative | - | ○ | 2.3 | 1.5 | 22000 (F) | 350 | A | B | B | B |
| Example 27 | negative | - | ○ | 2.3 | 1.5 | 22000 (F) | 350 | C | B | B | B |
| Example 28 | negative | - | ○ | 2.3 | 1.5 | < 50 | 350 | B | B+ | B | B |
| Example 29 | negative | - | ○ | 2.3 | 1.5 | < 50 | 350 | C | B+ | B | B |
| Example 30 | negative | - | × | 0.3 | 12.9 | 22000 (F) | 350 | B | A | C | B |
| Example 31 | negative | - | × | 16.0 | 0.2 | 22000 (F) | 350 | A | B | B | A |
| Example 32 | negative | - | ○ | 4.5 | 1.0 | 22000 (F) | 350 | A | A | A | B |
| Example 33 | negative | - | × | 0.9 | 4.5 | 22000 (F) | 350 | A | A | B | B |
| Example 34 | negative | - | ○ | 1.8 | 5.2 | 22000 (F) | 350 | B | B | C | B |
| Example 35 | negative | - | × | 4.8 | 0.3 | 22000 (F) | 350 | B | C | C | B |
| Example 36 | negative | MPA (4.3 parts by mass) | ○ | 2.4 | 1.5 | < 50 | 350 | A | A+ | A | A |
| Comparative Example 1 | positive | - | - | - | - | < 50 | 300 | F | D | D | E |
| Comparative Example 2 | negative | - | - | 4.0 | - | < 50 | 300 | B | D | D | E |

| | | | | | | | | | | | |
|---|---|---|---|---|---|---|---|---|---|---|---|
| * 1) Content with respect to 100 parts by mass of resin (A) | | | | | | | | | | | |

In the column "α > β ≥ γ" in Table 3, "∘" indicates that "α > β ≥ γ" is true, "×" indicates that "α > β ≥ γ" is not true, and "-" indicates that the relationship has not been determined. In addition, the elements detected in the column "Amount of halogen" are shown in parentheses for reference.

The above-described results show that the resin compositions of Examples have excellent heat resistance, excellent adhesion to a metal material, particularly to copper, and excellent migration resistance. The results of Comparative Example 1 and Comparative Example 2 have revealed that peeling of the cured film from the copper substrate was observed, and that the insulation reliability was also low.

## Claims

1. A photosensitive resin composition comprising a resin (A), a photosensitizer (B), a compound (C) represented by Formula (1), and a compound (D) represented by Formula (2): 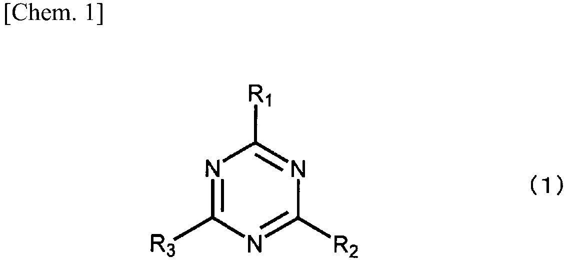
(wherein R₁ to R₃ are each independently a hydrogen atom, NR₄R₅, or L(R₆)ₛ; L is a C₆₋₁₀ n-valent organic group having an aromatic ring; R₄ and R₅ are each independently a hydrogen atom, -CH₂OH, -CH₂OCH₃, -CH₂OCH₂CH₂CH₂CH₃, or - CH₂OCH(CH₃)₂; R₆ is independently -CH₂OH, -CH₂OCH₃, -CH₂OCH₂CH₂CH₂CH₃, or -CH₂OCH(CH₃)₂; n is an integer of 1 to 3; s is an integer of 0 to 2; and n-s is 1), 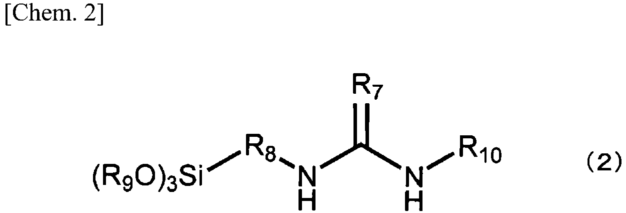
(wherein R₇ is an oxygen atom or a sulfur atom; R₈ is a C₁₋₄ divalent organic group; R₉ is a methyl group or an ethyl group; and R₁₀ is a C₁₋₁₈ monovalent hydrocarbon group or a C₆₋₁₂ monovalent aromatic group, wherein the C₁₋₁₈ monovalent hydrocarbon group and the C₆₋₁₂ monovalent aromatic group may contain a heteroatom).

2. The photosensitive resin composition according to claim 1, wherein all or part of the photosensitizer (B) is an oxime ester compound (B1-1).

3. The photosensitive resin composition according to claim 1 or 2, wherein the compound (C) represented by Formula (1) is contained in an amount of 30 parts by mass or more and 1200 parts by mass or less with respect to 100 parts by mass of the compound (D) represented by Formula (2).

4. The photosensitive resin composition according to claim 1 or 2, which satisfies α > β ≥ γ, satisfies 1.0 ≤ α/β ≤ 4.5, and satisfies 0.4 ≤ β/γ ≤ 5.0, assuming that the amount of the photosensitizer (B) contained in the photosensitive resin composition is α part(s) by mass, that the amount of the compound (C) represented by Formula (1) is β part(s) by mass, and the amount of the compound (D) represented by Formula (2) is γ part(s) by mass.

5. The photosensitive resin composition according to claim 1 or 2, further comprising one or both of a compound represented by Formula (5) and a compound represented by Formula (6): 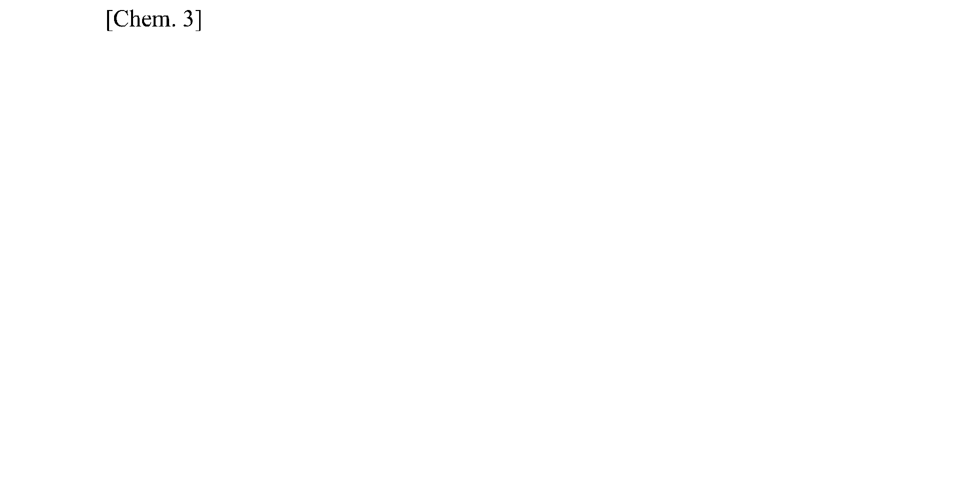 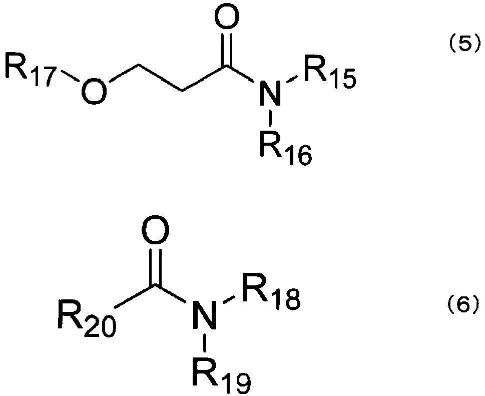 (wherein, in Formula (5), R₁₅, R₁₆, and R₁₇ are each independently a C₁₋₆ alkyl group; in Formula (6), R₁₈ and R₁₉ are each independently a C₁₋₆ alkyl group; and R₂₀ is a hydrogen atom or a C₁₋₆ alkyl group).

6. The photosensitive resin composition according to claim 1 or 2, wherein all or part of the compound (D) represented by Formula (2) is a compound having a structure represented by Formula (4): 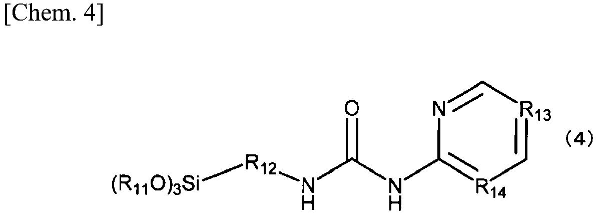 (wherein R₁₁ is a methyl group or an ethyl group; R₁₂ is a C₁₋₄ divalent organic group; and
R₁₃ and R₁₄ are each independently a carbon atom (i.e., a methine group) or a nitrogen atom).

7. The photosensitive resin composition according to claim 1 or 2, wherein all or part of the compound (C) represented by Formula (1) is a compound having a structure represented by Formula (3): 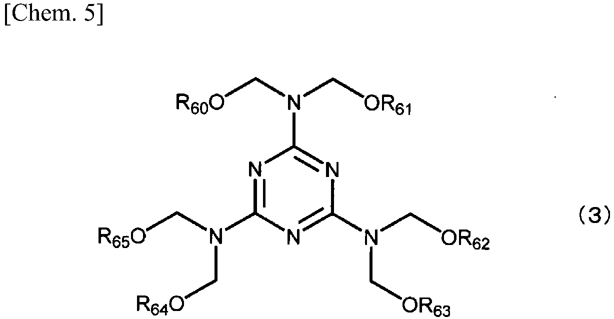 (wherein R₆₀ to R₆₅ are each independently a hydrogen atom, -CH₃, - CH₂CH₂CH₂CH₃, or -CH(CH₃)₂).

8. The photosensitive resin composition according to claim 1 or 2, wherein all or part of the resin (A) is one or more resins selected from the group consisting of a polyimide precursor (A-1), a polyimide (A-2), a polybenzoxazole precursor (A-3), a polybenzoxazole (A-4), and copolymers thereof.

9. The photosensitive resin composition according to claim 8, wherein the one or more resins selected from the group consisting of the polyimide precursor (A-1), the polyimide (A-2), the polybenzoxazole precursor (A-3), the polybenzoxazole (A-4), and the copolymers thereof contain(s) a phenolic hydroxyl group.

10. The photosensitive resin composition according to claim 8, wherein all or part of the resin (A) is a polyimide precursor containing a repeating structural unit represented by Formula (7), or is a copolymer of the polyimide precursor. 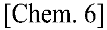 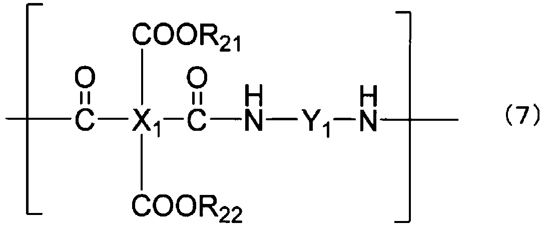 (wherein X₁ is a tetravalent group having a C₂₋₂₀ aliphatic structure, a C₄₋₂₀ alicyclic structure, or a C₄₋₄₀ aromatic structure; Y₁ is a divalent organic group having a C₂₋₂₀ aliphatic structure, a C₄₋₂₀ alicyclic structure, or a C₄₋₄₀ aromatic structure; and R₂₁ and R₂₂ are each independently a hydrogen atom, a C₁₋₂₀ alkyl group, or a monovalent organic group having an ethylene-type unsaturated double bond).

11. The photosensitive resin composition according to claim 10, wherein the polyimide precursor has an esterification rate of 40 mol% or more and 80 mol% or less.

12. The photosensitive resin composition according to claim 10, wherein all or part of the structure of X₁ in Formula (7) is a structure represented by Formula (8):
[Chem. 7]
(wherein, in Formula (8), * is a binding site that binds to an amide structure, a carboxylic acid structure, or a carboxylic acid ester structure).

13. The photosensitive resin composition according to claim 1 or 2, wherein the photosensitive resin composition contains a halogen element(s) in an amount of 50 ppm or less.

14. A cured product obtained by curing the photosensitive resin composition according to claim 1 or 2.

15. An electronic component comprising the cured product according to claim 14.

16. The electronic component according to claim 15, wherein the electronic component comprises: a silicon substrate, a silicon carbide substrate, or a gallium nitride substrate, wherein the cured product is provided on the substrate.
